# EUROPEAN PATENT APPLICATION

(11) **EP 4 564 436 A1**
(43) Date of publication of application: **04.06.2025**
(21) Application number: 24184089.1
(22) Date of filing: 24.06.2024
(51) Int. Cl.: H01L 29/10, H01L 29/417, H01L 29/423, H01L 29/78, H01L 29/66, H01L 29/739, H01L 29/73

(54) **SEMICONDUCTOR DEVICE**

(30) Priority: 29.11.2023 KR 20230169926
(71) Applicant: Samsung Electronics Co., Ltd., Suwon-si, Gyeonggi-do 16677 (KR)
(72) Inventor: PARK, Junhyuk, Suwon-si (KR); KIM, Jongseob, Suwon-si (KR); PARK, Young Hwan, Suwon-si (KR); OH, Jaejoon, Suwon-si (KR); CHO, Doohyung, Suwon-si (KR)
(74) Representative: Marks & Clerk LLP

(57) **Abstract**

The present disclosure relates to a semiconductor device, and a semiconductor device including a substrate (110), a first conductivity type epitaxial layer (131) on a first surface of the substrate and including a first trench(500), a gate electrode (150) inside the first trench, a gate insulating layer (140) between the first conductivity type epitaxial layer and the gate electrode, a source electrode (173) on the first conductivity type epitaxial layer, second conductivity type doped well regions (133) and first conductivity type doped layers (137) between the first conductivity type epitaxial layer and the source electrode, and a drain electrode (175) on a second surface of the substrate, the gate electrode has n number of side surfaces connecting a lower surface and a upper surface, and the angle of the side surfaces of the gate electrode with respect to the lower surface of the gate electrode are different from each other.

## Description

### BACKGROUND

### 1. Field of the Invention

The present disclosure relates to a semiconductor device.

### 2. Description of the Related Art

In the modern society, power semiconductor devices are becoming increasingly important in various fields such as the transportation field, for example, electric vehicles, trains, and electric trams, renewable energy systems (e.g., solar power generation and wind power generation), and mobile devices. Power semiconductor devices are semiconductor devices usable to handle high voltage or high current, and perform functions such as power conversion and control in large power systems and high-power electronic devices. Power semiconductor devices have the ability and durability to handle high power, allowing them to handle large amounts of current and withstand high voltages. For example, power semiconductor devices can handle voltages of hundreds to thousands of volts and currents of tens to thousands of amperes. Power semiconductor devices can improve the efficiency of electrical energy by minimizing power losses. Further, power semiconductor devices can be stably driven in environments such as high temperatures.

These power semiconductor devices can be categorized by their materials, and for example, include SiC power semiconductor devices and GaN power semiconductor devices. Instead of conventional silicon (Si) wafers, SiC or GaN may be used to manufacture power semiconductor devices, whereby it is possible to compensate for the disadvantages of silicon having unstable characteristics at high temperatures. SiC power semiconductor devices are resistant to high temperatures and have low power loss, making them suitable for electric vehicles, renewable energy systems, and/or the like. GaN power semiconductor devices require high costs, but are efficient in terms of speed, making them suitable for fast charging of mobile devices and/or the like.

### SUMMARY

The present disclosure attempts to provide a semiconductor device that has stable electrical characteristics and improved reliability.

A semiconductor device according to at least one example embodiment includes a substrate having a first conductivity type; a first conductivity type epitaxial layer on a first surface of the substrate, the first conductivity type epitaxial layer including a first trench; a gate electrode inside the first trench; a gate insulating layer insulating the first conductivity type epitaxial layer from the gate electrode; a source electrode on the first conductivity type epitaxial layer; second conductivity type doped well regions and first conductivity type doped layers between the first conductivity type epitaxial layer and the source electrode; and a drain electrode on a second surface of the substrate, wherein the gate electrode includes a lower surface facing a bottom surface of the first trench, an upper surface opposite to the lower surface, and n number of side surfaces connecting the lower surface and the upper surface, wherein an angle of the m-th side surface of the gate electrode with respect to the lower surface of the gate electrode is different from an angle of the (m-1)-th side surface of the gate electrode with respect to the lower surface of the gate electrode, wherein n is a natural number greater than 2, and wherein m is equal to or smaller than n.

In some embodiments, the angle of the m-th side surface of the gate electrode with respect to the lower surface of the gate electrode may be different from the angle of the (m-1)-the side surface of the gate electrode with respect to the lower surface of the gate electrode for only one or more of the values of m between 2 and n or alternatively may be different for each value of m between 2 and n. Similarly, the other conditions described herein relating to the m-th side surface and m-1-th side surface (e.g. the m-th side surface being closer to the lower surface than the (m-1)-th side surface) may apply for only one or more of the values of m between 2 and n or alternatively may apply for each value of m between 2 and n. Furthermore, the other conditions described herein relating to the m-th side wall of the first trench and the (m-1)-th side wall of the first trench (e.g. the angle of the m-th side wall with respect to the bottom surface being different from the angle of the (m-1)-th side wall with respect to the bottom surface) may apply for only one or more of the values of m between 2 and n or alternatively may apply for each value of m between 2 and n.

The m-side surface and the (m-1)-th side surface may be surfaces that are connected to one another. For example, the side surfaces connecting the lower surface of the gate electrode to the upper surface of the gate electrode along one side of the gate electrode may include a first side surface and a second side surface connected to the first side surface. The first side surface may be positioned further from the lower surface and closer to the upper surface than the second side surface. The m-side surface may correspond to the second side surface and the (m-1)-th side surface may correspond to the first side surface.

The first conductivity type and the second conductivity type may refer to the doping type (i.e. p-type doping or n-type doping) of the material. For example, the substrate having a first conductivity type (which may also be referred to as the first conductivity type substrate) and the first conductivity type epitaxial layer may be n-type doped, whereas the second conductivity type doped well regions may be p-type doped.

In some embodiments, the second conductivity type doped well region includes: an inner bottom surface facing a bottom surface of the second trench; and k number of side surfaces extending from the inner bottom surface, and an angle of the j-th side surface of the second conductivity type doped well region with respect to the inner bottom surface of the second conductivity type doped well region is different from an angle the (j-1)-th side surface of the second conductivity type doped well region with respect to the inner bottom surface of the second conductivity type doped well region, and k is a natural number greater than 2, and j is equal to or smaller than k.

In some embodiments, the angle of the j-th side surface with respect to the inner bottom surface may be different from the angle of the (j-1)-the side surface of the gate electrode with respect to the lower surface of the gate electrode for only one or more of the values of j between 2 and k or alternatively may apply for each value of j between 2 and k. Similarly, other conditions described herein relating to the j-th side surface and j-1-th side surface may apply for only one or more of the values of j between 2 and k or alternatively may apply for each value of j between 2 and k.

The j-th side surface and the (j-1)-th side surface may be surfaces that are connected to one another. For example, the side surfaces may include a first side surface and a second side surface connected to the first side surface. The first side surface may be positioned further from the inner bottom surface and closer to the upper surface than the second side surface. The j-th side surface may correspond to the second side surface and the (j-1)-th side surface may correspond to the first side surface.

In some embodiments, angles of the n number of side surfaces of the gate electrode with respect to the lower surface of the gate electrode increase from the n-th side surface extending from the lower surface of the gate electrode to a first side surface extending down from the upper surface of the gate electrode.

In some embodiments, angles of the n number of side walls of the first trench with respect to the bottom surface of the first trench increase from the n-th side wall of the first trench, extending from the bottom surface of the first trench, to the first side wall of the first trench positioned at the top of the first trench.

In some embodiments, angles of the k number of side surfaces of the second conductivity type doped well region with respect to the inner bottom surface of the second conductivity type doped well region increase from the k-th side surface extending from the inner bottom surface of the second conductivity type doped well region to the first side surface adjacent to the first conductivity type doped layers.

A semiconductor device according to at least one example embodiment includes a substrate having a first conductivity type; a first conductivity type epitaxial layer on a first surface of the substrate and including a first trench and a second trench spaced apart from the first trench; a gate electrode inside the first trench; a gate insulating layer insulating the first conductivity type epitaxial layer from the gate electrode; a source electrode on the first conductivity type epitaxial layer; a second conductivity type doped well region in the second trench and between the first conductivity type epitaxial layer and the source electrode; a first conductivity type doped layer between at least a portion of the second conductivity type doped well regions and the source electrode; and a drain electrode on a second surface of the substrate, wherein the second conductivity type doped well region includes an inner bottom surface facing the bottom surface of the second trench, and k number of side surfaces extending from the inner bottom surface, and wherein an angle of the j-th side surface of the second conductivity type doped well region with respect to the inner bottom surface of the second conductivity type doped well region is different from an angle of the (j-1)-th side surface of the second conductivity type doped well region with respect to the inner bottom surface of the second conductivity type doped well region, k is a natural number greater than 2, and j is equal to or smaller than k.

A semiconductor device according to at least one example embodiment includes a substrate having first conductivity type; a first conductivity type epitaxial layer on a first surface of the substrate and including a first trench and a second trench spaced apart from the first trench; a gate electrode inside the first trench; a gate insulating layer insulating the first conductivity type epitaxial layer from the gate electrode; a source electrode on the first conductivity type epitaxial layer; a second conductivity type doped well region between the first conductivity type epitaxial layer and the source electrode in the second trench; first conductivity type doped layers between at least a portion of the second conductivity type doped well regions and the source electrode; and a drain electrode on a second surface of the substrate, wherein the first trench includes a bottom surface, and n number of side walls extending from the bottom surface of the first trench, and wherein angles of the n number of side walls of the first trench with respect to the bottom surface gradually increase from the n-th side wall extending from the bottom surface of the first trench to the first side wall positioned at the top of the first trench, wherein the second trench includes a bottom surface, and k number of side walls extending from the bottom surface of the second trench, and wherein angles of the k number of side walls of the second trench with respect to the bottom surface gradually increase from the k-th side wall extending from the bottom surface of the second trench to the first side wall positioned at the top of the second trench.

According to the at least one example embodiments, it is possible to improve the electrical characteristics and reliability of the semiconductor devices.

At least some of the above and other features of the invention are set out in the claims.

### BRIEF DESCRIPTION OF THE DRAWINGS

FIG. 1 is a cross-sectional view illustrating a semiconductor device according to at least one example embodiment.
FIGS. 2 and 3 are drawings illustrating the angles and heights of some components of the semiconductor device according to the at least one example embodiment shown in FIG. 1.
FIG. 4 is a drawing illustrating the flow of current in the semiconductor device according to the at least one example embodiment shown in FIG. 1.
FIGS. 5 to 9 are cross-sectional views illustrating semiconductor devices according to some example embodiments.
FIG. 10 is a flow chart illustrating a method of manufacturing a semiconductor device according to at least one example embodiment.
FIGS. 11 to 21 are cross-sectional views illustrating processes of the method of manufacturing the semiconductor device according to the at least one example embodiment in the order of the processes.
FIG. 22 is a flow chart illustrating a method of manufacturing a semiconductor device according to at least one example embodiment.
FIGS. 23 and 24 are cross-sectional views illustrating some processes of the method of manufacturing the semiconductor device according to the at least one example embodiment.
FIG. 25 is a flow chart illustrating a method of manufacturing a semiconductor device according to at least one example embodiment.
FIGS. 26 to 29 are cross-sectional views illustrating some processes of the method of manufacturing the semiconductor device according to the at least one example embodiment.
FIG. 30 is a schematic of an electronic device according to at least one embodiment.

### DETAILED DESCRIPTION

In the following detailed description, only certain some example embodiments have been shown and described, simply by way of illustration. The present invention can be variously implemented and is not limited to the following some example embodiments.

The drawings and description are to be regarded as illustrative in nature and not restrictive. Like reference numerals designate like elements throughout the specification.

In addition, the size and thickness of each configuration shown in the drawings are arbitrarily shown for understanding and ease of description, but the present invention is not limited thereto. In the drawings, the thicknesses of layers, films, panels, regions, etc., are exaggerated for clarity. Further, in the drawings, for understanding and ease of description, the thickness of some layers and areas is exaggerated. Additionally, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry. Additionally, whenever a range of values is enumerated, the range includes all values within the range as if recorded explicitly clearly, and may further include the boundaries of the range. Accordingly, the range of "X" to "Y" includes all values between X and Y, including X and Y

Further, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity. Therefore, it will also be understood that such spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly.

In addition, unless explicitly described to the contrary, the word "comprise", and variations such as "comprises" or "comprising", will be understood to imply the inclusion of stated elements but not the exclusion of any other elements.

Further, in the entire specification, when it is referred to as "on a plane", it means when a target part is viewed from above, and when it is referred to as "on a cross-section", it means when the cross-section obtained by cutting a target part vertically is viewed from the side.

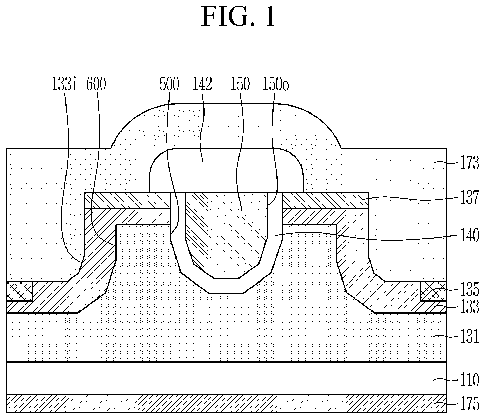

Hereinafter, a semiconductor device according to at least one example embodiment will be described below with reference to FIGS. 1 to 4.

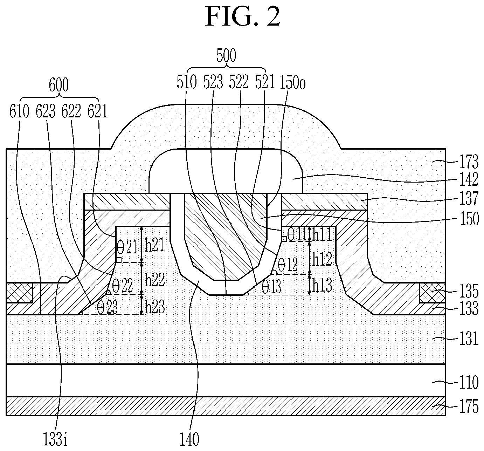

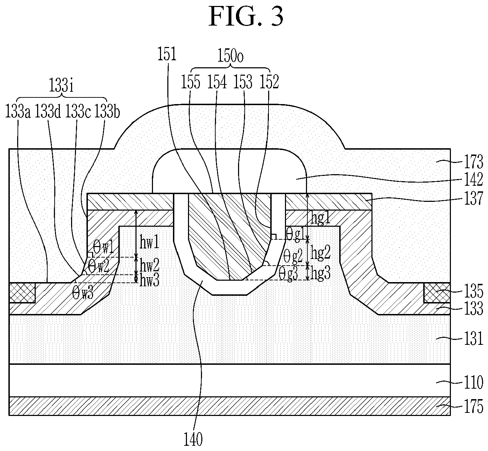

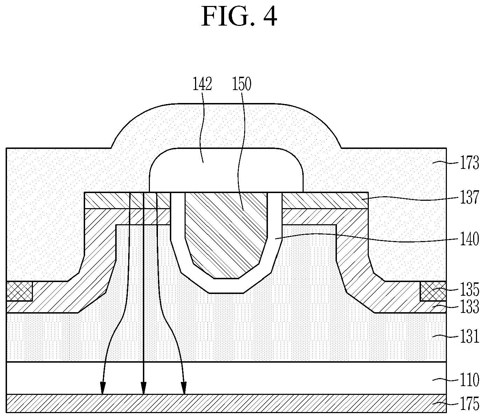

FIG. 1 is a cross-sectional view illustrating a semiconductor device according to at least one example embodiment. FIGS. 2 and 3 are drawings illustrating the angles and heights of some components of the semiconductor device according to the at least one example embodiment shown in FIG. 1. FIG. 4 is a drawing illustrating the flow of current in the semiconductor device according to the at least one example embodiment shown in FIG. 1.

As shown in FIG. 1, a semiconductor device according to at least one example embodiment includes a first conductivity type substrate 110, a first conductivity type epitaxial layer 131 that is positioned on a first surface of the first conductivity type substrate 110, a gate electrode 150 that is positioned on the first conductivity type epitaxial layer 131, a gate insulating layer 140 that is positioned between the first conductivity type epitaxial layer 131 and the gate electrode 150, a source electrode 173 that is positioned on the first conductivity type epitaxial layer 131, second conductivity type doped well regions 133 and first conductivity type doped layers 137 that are positioned between the first conductivity type epitaxial layer 131 and the source electrode 173, and a drain electrode 175 that is positioned on a second surface of the first conductivity type substrate 110.

The first conductivity type substrate 110 may be (and/or include) a semiconductor substrate including silicon carbide (SiC). The semiconductor substrate may include one or more polymorphs of SiC. For example, the first conductivity type substrate 110 may comprise and/or consist of a 4H SiC substrate, a 3C SiC substrate, a 6H SiC substrate, and/or the like. In at least one embodiment, the first conductivity type substrate 110 may be an n-type doped substrate. The first conductivity type substrate 110 may be a highly n-type doped substrate. In at least one embodiment, the resistivity of the first conductivity type substrate 110 may be in a range from about 0.005 Ωcm to about 0.035 Ωcm. The thickness of the first conductivity type substrate 110 may be in a range from about 200 µm to about 700 µm. However, the material, doping type, doping concentration, resistivity, thickness, and/or the like of the first conductivity type substrate 110 are not limited thereto, and may be variously changed. The first conductivity type substrate 110 may have a first surface and a second surface facing each other. For example, the first surface of the first conductivity type substrate 110 may be the upper surface, and the second surface of the first conductivity type substrate 110 may be the lower surface.

The first conductivity type epitaxial layer 131 may be positioned on the first surface of the first conductivity type substrate 110. In at least one embodiment, the first conductivity type epitaxial layer 131 may be an epitaxy layer formed on the first conductivity type substrate 110 by epitaxial growth, and therefore the lower surface of the first conductivity type epitaxial layer 131 may be in direct contact with the upper surface of the first conductivity type substrate 110. However, the present disclosure is not limited thereto, and other layers may be further positioned between the first conductivity type substrate 110 and the first conductivity type epitaxial layer 131. The first conductivity type epitaxial layer 131 may contain SiC. For example, the first conductivity type epitaxial layer 131 may contain 4H SiC. The first conductivity type epitaxial layer 131 may be an n-type doped layer. The first conductivity type epitaxial layer 131 may be a lowly n-type doped layer. The doping concentration of the first conductivity type epitaxial layer 131 may be lower than the doping concentration of the first conductivity type substrate 110. The doping concentration of the first conductivity type epitaxial layer 131 may be in a range from about 1×10¹⁵cm⁻³ to about 5×10¹⁶cm⁻³. The thickness of the first conductivity type epitaxial layer 131 may be in a range from about 7 µm to about 13 µm. The material, doping type, doping concentration, thickness, and/or the like of the first conductivity type epitaxial layer 131 are not limited thereto, and may be variously changed.

The first conductivity type epitaxial layer 131 may include a first trench 500. The first trench 500 may be formed in an upper surface of the first conductivity type epitaxial layer 131 so as to have a first predetermined (and/or otherwise determined) depth. The first trench 500 may be formed so as to have a substantially U-shaped cross section. As such, the first trench 500 may have a bottom surface and two sets of side walls extending from the bottom surface when viewed in cross-section. The angles between the side walls of each of the sets of the first trench 500 with respect to the bottom surface may be different from each other (e.g., may be not constant). This will be further described below with reference to FIG. 2. The first trench 500 may further have circular, ovoid, bar, etc. shape when seen in a plan view.

The first conductivity type epitaxial layer 131 may further include second trenches 600. The second trenches 600 may be formed in the upper surface of the first conductivity type epitaxial layer 131 so as to have a second predetermined (and/or otherwise determined) depth. The second trenches 600 may be positioned so as to be spaced apart from the first trench 500. The second trenches 600 may be positioned on both sides of the first trench 500. The second trenches 600 that are positioned on both sides of the first trench 500 may or may not be connected to each other. For example, a second trench 600 may be formed in a donut shape so as to surround the first trench 500 when seen in the plan view, may be formed so as to have a substantially U-shaped cross section, or may be formed as two non-intersecting trenches. As such, in the drawings, only some portions of the second trenches 600 formed in the donut shape and the U shape are shown. Each second trench 600 may include a bottom surface, and side walls extending from the bottom surface. The angles of the side walls of the second trench 600 with respect to the bottom surface may be different from each other (e.g., may be not constant). This will be further described below with reference to FIG. 2.

The gate electrode 150 may be positioned in the first trench 500 of the first conductivity type epitaxial layer 131. The gate electrode 150 may be spaced apart from the first conductivity type epitaxial layer 131. The gate electrode 150 may be spaced apart from the first conductivity type epitaxial layer 131 at an appropriately constant interval. However, the present disclosure is not limited thereto, and the separation distance between the gate electrode 150 and the first conductivity type epitaxial layer 131 may vary depending on the positions of the gate electrode 150 and the first conductivity type epitaxial layer 131. The gate electrode 150 may have a cross-sectional shape the same as and/or substantially similar to that of the first trench 500. For example, the gate electrode 150 may have a lower surface, and two sets of side surfaces extending from the lower surface when viewed in cross-section, and the lower surface and side surfaces of the gate electrode 150 may form an appropriately U shape conforming to the shape of the first trench 500 as seen in the cross-sectional view. The gate electrode 150 may further have an upper surface facing the lower surface, and the side surfaces may connect the lower surface and the upper surface. The lower surface of the gate electrode 150 may face the bottom surface of the first trench 500. The side surfaces of the gate electrode 150 may face the side walls of the first trench 500. The angles of the individual side surfaces of each of the sets of side surfaces of the gate electrode 150 with respect to the lower surface may be different. This will be further described below with reference to FIG. 3.

The gate electrode 150 may contain a conductive material. For example, the gate electrode 150 may contain polysilicon doped with impurities, a metal, a metal alloy, a conductive metal nitride, a metal silicide, a doped semiconductor material, a conductive metal oxide, a conductive metal oxynitride, a combination thereof, and/or the like. The gate electrode 150 may include a single layer or multiple layers.

The gate insulating layer 140 may be positioned between the first conductivity type epitaxial layer 131 and the gate electrode 150. For example, the gate insulating layer 140 may be positioned below the gate electrode 150, and may cover the lower surface of the gate electrode 150 and/or may be positioned above the first conductivity type epitaxial layer 131 and may cover the bottom surface of the first conductivity type epitaxial layer 131. The gate electrode 150 may be insulated from the first conductivity type epitaxial layer 131 by the gate insulating layer 140. The gate electrode 150 may be surrounded by the gate insulating layer 140.

In at least one embodiment, the thickness of the gate insulating layer 140 may be substantially constant. Accordingly, the distance between the gate electrode 150 and the first conductivity type epitaxial layer 131 may be almost constant. Similarly, the distance between the gate electrode 150 and the second conductivity type doped well region 133 and the distances between the gate electrode 150 and the first conductivity type doped layers 137 may also be substantially constant.

The gate insulating layer 140 may contain an insulating material. For example, the gate insulating layer 140 may contain SiO₂. However, the material of the gate insulating layer 140 is not limited thereto, and may be variously changed. As an example, the gate insulating layer 140 may contain SiN, SiON, SiC, SiCN, a combination thereof, and/or the like. The gate insulating layer 140 may include a single layer or multiple layers.

The semiconductor device according to the at least one example embodiment may further include a capping layer 142 that is positioned on the gate electrode 150. The capping layer 142 may cover the upper surface of the gate electrode 150. Further, the capping layer 142 may cover gate insulating layer 140 and at least some portions of the first conductivity type doped layers 137 adjacent to the gate electrode 150. The capping layer 142 may be positioned between the gate electrode 150 and the source electrode 173. The gate electrode 150 may be insulated from the source electrode 173 by the capping layer 142.

The thickness of the capping layer 142 may be almost constant in the portion overlapping the gate electrode 150 in the vertical direction. The capping layer 142 may further include at least one region wherein thickness of the capping layer 142 may gradually decrease from the center toward both edges. The thickness of the capping layer 142 may be different from the thickness of the gate insulating layer 140. For example, the thickness of the capping layer 142 may be larger than the thickness of the gate insulating layer 140. In some cases, the thickness of the capping layer 142 may be similar to the thickness of the gate insulating layer 140.

The capping layer 142 may contain an insulating material. For example, the capping layer 142 may contain SiO₂, SiOP, SiN, SiON, a combination thereof, and/or the like. However, the material of the capping layer 142 is not limited thereto, and may be variously changed. The capping layer 142 may include a single layer or multiple layers. The capping layer 142 may contain the same material as that of the gate insulating layer 140, or may contain a material different from that of the gate insulating layer. When the capping layer 142 is formed of the same material as that of the gate insulating layer 140, the boundary between the capping layer 142 and the gate insulating layer 140 may not be clearly distinguishable at the portion where the capping layer 142 and the gate insulating layer 140 abut.

The source electrode 173 may be positioned on the first conductivity type epitaxial layer 131. The source electrode 173 may also be positioned on the gate electrode 150. The source electrode 173 may be spaced apart from and/or electrically insulated from the gate electrode 150 by the capping layer 142. The width of the capping layer 142 that is positioned between the gate electrode 150 and the source electrode 173 may be larger than the width of the gate electrode 150. In this case, the width of the capping layer 142 and the width of the gate electrode 150 may refer to their widths along a direction parallel with the upper surface of the first conductivity type substrate 110. The lower surface of the source electrode 173 may be in contact with the capping layer 142. However, the present disclosure is not limited thereto, and other predetermined layers may be further positioned between the source electrode 173 and the capping layer 142.

The source electrode 173 may contain a conductive material. For example, the source electrode 173 may contain a metal, a metal alloy, a conductive metal nitride, a metal silicide, a doped semiconductor material, a conductive metal oxide, a conductive metal oxynitride, a combination thereof, and/or the like.

For example, the source electrode 173 may include at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbo-nitride (TiAlC-N), titanium aluminum carbide (TiAlC), titanium carbide (TiC), tantalum carbo-nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and/or a combination thereof, but is not limited thereto. The source electrode 173 may include a single layer or multiple layers.

The second conductivity type doped well regions 133 may be positioned on the first conductivity type epitaxial layer 131. At least a portion of each second conductivity type doped well region 133 may be positioned in a second trench 600 of the first conductivity type epitaxial layer 131. The other portions of the second conductivity type doped well regions 133 may be positioned on the portions of the first conductivity type epitaxial layer 131 positioned between the first trench 500 and the second trenches 600. The second conductivity type doped well regions 133 may face the gate electrode 150 with the gate insulating layer 140 interposed therebetween. The surfaces of the second conductivity type doped well regions 133 facing the gate electrode 150 may be positioned on the same boundary lines as the side walls of the first trench 500. The second conductivity type doped well regions 133 may not be positioned in the first trench 500 of the first conductivity type epitaxial layer 131. However, the positions of the second conductivity type doped well regions 133 are not limited by the above descriptions, and may be variously changed. For example, in at least one embodiment, the second conductivity type doped well regions 133 may be omitted from the portions of the first conductivity type epitaxial layer 131 positioned between the first trench 500 and the second trenches 600.

The second conductivity type doped well regions 133 may be positioned between the first conductivity type epitaxial layer 131 and the source electrode 173. In at least one embodiment, the surface of each second conductivity type doped well region 133 may be in contact with the first conductivity type epitaxial layer 131, and the opposite surface of the corresponding second conductivity type doped well region 133 may be in contact with the source electrode 173. However, the present disclosure is not limited thereto, and other predetermined layers may be positioned between the second conductivity type doped well regions 133 and the source electrode 173, and other predetermined (and/or otherwise determined) layers may be positioned between the second conductivity type doped well regions 133 and the first conductivity type epitaxial layer 131.

The second conductivity type doped well regions 133 may be positioned on the first conductivity type epitaxial layer 131 so as to conform to the first conductivity type epitaxial layer 131. Accordingly, the portions of the second conductivity type doped well regions 133 that are positioned in the second trenches 600 of the first conductivity type epitaxial layer 131 may be formed so as to have the same and/or substantially similar shaped cross sections with respect to the shapes of the second trenches 600. In the drawings, only some portions of the second conductivity type doped well regions 133 having a U shape are shown. The second conductivity type doped well regions 133 may be positioned on the bottom surfaces and side surfaces of the second trenches 600 so as to conform to them. Accordingly, the entire second trenches 600 may not be filled by the second conductivity type doped well regions 133. Additionally, at least a portion of each second trench 600 may be filled by the source electrode 173. The portions of the source electrode 173 that are positioned in the second trenches 600 may be relatively thicker than the other portions the source electrode 173. One surface of each second conductivity type doped well region 133 abutting the first conductivity type epitaxial layer 131 inside a second trench 600 may have substantially the same cross-sectional shape as that of the corresponding second trench 600. The opposite surface of each second conductivity type doped well region 133 abutting the source electrode 173 inside a second trench 600 may have a cross-sectional shape similar to that of the corresponding second trench 600. The opposite surfaces of the second conductivity type doped well regions 133 may include inner bottom surfaces and side surfaces extending from the inner bottom surfaces. The inner bottom surfaces of the second conductivity type doped well regions 133 may face the bottom surfaces of the second trenches 600. The angles of the individual side surfaces of the second conductivity type doped well regions 133 with respect to their inner bottom surfaces may be different. This will be further described below with reference to FIG. 3.

The second conductivity type doped well regions 133 may be epitaxy layers formed from and/or on the first conductivity type epitaxial layer 131 by an epitaxial growth method. Alternatively, the second conductivity type doped well regions 133 may be doped regions formed in the first conductivity type epitaxial layer 131 by an ion implantation process. When the second conductivity type doped well regions 133 are formed by an ion implantation process, the second trenches 600 of the first conductivity type epitaxial layer 131 may not be ones formed by patterning. Second preliminary trenches of the first conductivity type epitaxial layer 131 may be formed by patterning, and then the second conductivity type doped well regions 133 may be formed to a predetermined depth from the second preliminary trenches by an ion implantation process. Accordingly, the second trenches 600 to be mentioned in the following description may be understood as referring to the boundaries between the first conductivity type epitaxial layer 131 and the second conductivity type doped well regions 133.

The second conductivity type doped well regions 133 may contain the same base material as the first conductivity type epitaxial layer 131. For example, in at least one embodiment, the second conductivity type doped well regions 133 may contain SiC. For example, the second conductivity type doped well regions 133 may contain 4H SiC. The second conductivity type doped well regions 133 may be doped p-type regions. The second conductivity type doped well regions 133 may be a lowly doped p-type regions. The doping concentration of the second conductivity type doped well regions 133 may be in a range from about 1×10¹⁷cm⁻³ to about 1×10¹⁹cm⁻³. The thickness of the second conductivity type doped well regions 133 may be in a range from about 0.3 µm to about 1.1 µm. The material, doping type, doping concentration, thickness, and/or the like of the second conductivity type doped well regions 133 are not limited thereto, and may be variously changed.

The semiconductor device according to the at least one example embodiment may further include second conductivity type doped layers 135 that are positioned between the second conductivity type doped well regions 133 and the source electrode 173. The second conductivity type doped layers 135 may be positioned inside the second trenches 600. The second conductivity type doped layers 135 may be formed in at least some regions of the second conductivity type doped well regions 133 in an ion implantation manner. Accordingly, the second conductivity type doped layers 135 may be formed to a predetermined depth from the front surfaces of the second conductivity type doped well regions 133. For example, the second conductivity type doped layers 135 may be formed to the predetermined depth from the inner bottom surfaces of the second conductivity type doped well regions 133. The second conductivity type doped layers 135 may be positioned inside the second trenches 600. The second conductivity type doped layers 135 may be spaced apart from the first conductivity type epitaxial layer 131. In other words, the second conductivity type doped layers 135 may not abut the first conductivity type epitaxial layer 131. Between the second conductivity type doped layers 135 and the first conductivity type epitaxial layer 131, the second conductivity type doped well regions 133 may be positioned.

The second conductivity type doped layers 135 may contain the same base material as the first conductivity type epitaxial layer 131 and/or the second conductivity type doped well regions 133. For example, in at least one embodiment, the second conductivity type doped layers 135 may contain SiC. For example, the second conductivity type doped layers 135 may contain 4H SiC. The second conductivity type doped layers 135 may be doped p-type layers. The second conductivity type doped layers 135 may be highly doped p-type layers. The doping concentration of the second conductivity type doped layers 135 may be higher than the doping concentration of the second conductivity type doped well regions 133. The doping concentration of the second conductivity type doped layers 135 may be in a range from about 1×10¹⁸cm⁻³ to about 5×10²⁰cm⁻³. The thickness of the second conductivity type doped layers 135 may be in a range from about 0.2 µm to about 1.0 µm. The material, doping type, doping concentration, and/or the like of the second conductivity type doped layers 135 are not limited thereto, and may be variously changed.

The first conductivity type doped layers 137 may be positioned between the second conductivity type doped well regions 133 and the source electrode 173. The first conductivity type doped layers 137 may be positioned on the portions of the first conductivity type epitaxial layer 131 positioned between the first trench 500 and the second trenches 600. The width of the first conductivity type doped layers 137 may be larger than the distances between the first trench 500 and the second trenches 600. The regions between the first trench 500 and the second trenches 600 may be covered by the first conductivity type doped layers 137. Further, at least some portions of the second trenches 600 may be covered by the first conductivity type doped layers 137. For example, the first conductivity type doped layers 137 may extend onto a region of the second conductivity type doped well regions 133 included in the second trenches 600. The first conductivity type doped layers 137 may face the gate electrode 150 with the gate insulating layer 140 interposed therebetween. The surfaces of the first conductivity type doped layers 137 facing the gate electrode 150 may be positioned on the same boundary lines as the side walls of the first trench 500. As such, the first conductivity type doped layers 137 may not cover the first trench 500. The upper surfaces of the first conductivity type doped layers 137 may abut the source electrode 173, and the lower surfaces of the first conductivity type doped layers 137 may abut the second conductivity type doped well regions 133. The source electrode 173 may be in ohmic contact with the first conductivity type doped layers 137. The regions in the first conductivity type doped layers 137 that abut the source electrode 173 may have a relatively higher doping concentration than those of the other regions. However, the present disclosure is not limited thereto, and between the first conductivity type doped layers 137 and the source electrode 173, other predetermined (and/or otherwise determined) layers may be positioned, and/or between the first conductivity type doped layers 137 and the second conductivity type doped well regions 133, other predetermined (and/or otherwise determined) layers may be positioned. For example, between the first conductivity type doped layers 137 and the source electrode 173, metal silicide layers may be positioned. By the metal silicide layers, the first conductivity type doped layers 137 and the source electrode 173 may be smoothly electrically connected. At least some portions of the upper surfaces of the first conductivity type doped layers 137 may be covered by the capping layer 142. The capping layer 142 may be positioned between the first conductivity type doped layers 137 and the source electrode 173.

The first conductivity type doped layers 137 may be doped regions formed in the first conductivity type epitaxial layer 131 and/or the second conductivity regions 133, e.g., by an ion implantation process. The first conductivity type doped layers 137 may contain, therefore, the same base material as the first conductivity type epitaxial layer 131. For example, in at least one embodiment, the second conductivity type doped well regions 133 may contain SiC. For example, the first conductivity type doped layers 137 may contain 4H SiC. The first conductivity type doped layers 137 may be n-type doped layers. The first conductivity type doped layers 137 may be highly n-type doped layers. The doping concentration of the first conductivity type doped layers 137 may be in a range from about 1×10¹⁸cm⁻³ to about 5×10²⁰cm⁻³. The thickness of the first conductivity type doped layers 137 may be in a range from about 0.1 µm to about 0.5 µm. The material, doping type, doping concentration, and/or the like of the first conductivity type doped layers 137 are not limited thereto, and may be variously changed.

The drain electrode 175 may be positioned on the second surface of the first conductivity type substrate 110 (e.g., the lower surface). The upper surface of the drain electrode 175 may abut the lower surface of the first conductivity type substrate 110. The drain electrode 175 may be in ohmic contact with the first conductivity type substrate 110. The region in the first conductivity type substrate 110 that abuts the drain electrode 175 may have a relatively higher doping concentration than that of the other region. However, the present disclosure is not limited thereto, and between the drain electrode 175 and the first conductivity type substrate 110, other predetermined layers may be further positioned. For example, between the drain electrode 175 and the first conductivity type substrate 110, a metal silicide layer may be positioned. By the metal silicide layer, the drain electrode 175 and the first conductivity type substrate 110 may be smoothly electrically connected.

The drain electrode 175 may contain a conductive material. For example, the drain electrode 175 may contain at least one of a metal, a metal alloy, a conductive metal nitride, a metal silicide, a doped semiconductor material, a conductive metal oxide, a conductive metal oxynitride, a combination thereof, and/or the like. The drain electrode 175 may be formed of the same material as that of the source electrode 173, or may be formed of a material different from that of the source electrode. The drain electrode 175 may include a single layer or multiple layers.

Hereinafter, the shapes of the first trench 500 and the second trenches 600 in the first conductivity type epitaxial layer 131 will be described in more detail with reference to FIG. 2.

As shown in FIG. 2, the first trench 500 of the first conductivity type epitaxial layer 131 may have a bottom surface 510, and a plurality of side walls (e.g., 521, 522, and 523) extending from the bottom surface 510. The side walls 521, 522, and 523 may include a first side wall 521, a second side wall 522, and a third side wall 523. The first side wall 521 may be positioned at the top of the first trench 500. The first side wall 521 may extend from the upper surface of the first conductivity type epitaxial layer 131 positioned outside the first trench 500. The second side wall 522 may extend from the first side wall 521, and be connected between the first side wall 521 and the third side wall 523. The third side wall 523 may extend from the second side wall 522, and be connected between the second side wall 522 and the bottom surface 510.

At least some of the angles of the side walls 521, 522, and 523 of the first trench 500 with respect to the bottom surface 510 will be different from one another. For example, in the first trench 500, the angle θ11 of the first side wall 521 with respect to the bottom surface 510, the angle θ12 of the second side wall 522 with respect to the bottom surface 510, and the angle θ13 of the third side wall 523 with respect to the bottom surface 510 may be different from one another. In the first trench 500, the angle θ11 of the first side wall 521 with respect to the bottom surface 510 may be equal to or larger than the angle θ12 of the second side wall 522 with respect to the bottom surface 510. In the first trench 500, the angle θ12 of the second side wall 522 with respect to the bottom surface 510 may be equal to or larger than the angle θ13 of the third side wall 523 with respect to the bottom surface 510. The angle θ11 of the first side wall 521 of the first trench 500 with respect to the bottom surface 510 may be in a range from about 75° to about 90°. The angle θ12 of the second side wall 522 of the first trench 500 with respect to the bottom surface 510 may be in a range from about 40° to about 75°. The angle θ13 of the third side wall 523 of the first trench 500 with respect to the bottom surface 510 may be in a range from about 0° to about 40°.

Although it has been described that the side walls of the first trench 500 include three sections having different inclination angles with respect to the bottom surface, the present disclosure is not limited thereto. The side walls of the first trench 500 may include two or more sections having different inclination angles with respect to the bottom surface. In other words, the first trench 500 may include n number of side walls extending from the bottom surface 510, wherein n may be a natural number equal to or greater than 2. The angle of the m-th side wall of the first trench 500 with respect to the bottom surface 510 of the first trench 500 may be different from the angle of the (m-1)-th side wall of the first trench 500 with respect to the bottom surface 510 of the first trench 500. In this case, m may be equal to or smaller than n. The angles of the n number of side walls of the first trench 500 with respect to the bottom surface 510 may gradually increase from the n-th side wall extending from the bottom surface 510 of the first trench 500 extending from the bottom surface 510 to the first side wall 521 positioned at the top of the first trench 500. For example, the angles between the sidewalls of the first trench 500 may increase until the angle θ11 of the first side wall 521 of the first trench 500, such that each angle is greater than a proceeding angle and angle θ11 is within a range from the proceeding angle and to 90° (e.g., θ1m ≤ θ1(m-1) ≤ ... ≤ θ11 ≤ 90°).

The shapes of side walls 521, 522, and 523 positioned on both sides of the first trench 500 with respect to the bottom surface 510 may be symmetrical. First side walls 521 may be positioned on both sides of the first trench 500 with respect to the bottom surface 510. Second side walls 522 may be positioned on both sides of the first trench 500 with respect to the bottom surface 510. Third side walls 523 may be positioned on both sides of the first trench 500 with respect to the bottom surface 510. In a plan view, the gate electrode 150 may be surrounded by the side walls 521, 522, and 523 of the first trench 500.

The heights of the side walls 521, 522, and 523 of the first trench 500 may be different from one another. The height of each of the side walls 521, 522, and 523 may refer to the length of the corresponding side wall of the side walls 521, 522, and 523 from one end to the other end along a direction perpendicular to the first conductivity type substrate 110. In the first trench 500, the height h11 of the first side wall 521, the height h12 of the second side wall 522, and the height h13 of the third side wall 523 may be different from one another. In the drawings, it is shown that the height h12 of the second side wall 522 is relatively greater than the height h11 of the first side wall 521 and the height h13 of the third side wall 523; however, this is merely an example, and their heights may be variously changed.

Each second trench 600 in the first conductivity type epitaxial layer 131 may include a bottom surface 610, and side walls 621, 622, and 623 extending from the bottom surface 610. The side walls 621, 622, and 623 may include a first side wall 621, a second side wall 622, and a third side wall 623. The first side wall 621 may be positioned at the top of the second trench 600. The first side wall 621 may extend from the upper surface of the first conductivity type epitaxial layer 131 positioned outside of the second trench 600. The second side wall 622 may extend from the first side wall 621, and be connected between the first side wall 621 and the third side wall 623. The third side wall 623 may extend from the second side wall 622, and be connected between the second side wall 622 and the bottom surface 610.

At least some of the angles of the side walls 621, 622, and 623 of the second trench 600 with respect to the bottom surface 610 will be different from one another. For example, in the second trench 600, the angle θ21 of the first side wall 621 with respect to the bottom surface 610, the angle θ22 of the second side wall 622 with respect to the bottom surface 610, and the angle θ23 of the third side wall 623 with respect to the bottom surface 610 may be different from one another. In the second trench 600, the angle θ21 of the first side wall 621 with respect to the bottom surface 610 may be equal to or larger than the angle θ22 of the second side wall 622 with respect to the bottom surface 610. The angle θ22 of the second side wall 622 with respect to the bottom surface 610 may be equal to or larger than the angle θ23 of the third side wall 623 with respect to the bottom surface 610. The angle θ21 of the first side wall 621 of the second trench 600 with respect to the bottom surface 610 may be in a range from about 75° to about 90°. The angle θ22 of the second side wall 622 of the second trench 600 with respect to the bottom surface 610 may be in a range from about 40° to about 75°. The angle θ23 of the third side wall 623 of the second trench 600 with respect to the bottom surface 610 may be in a range from about 0° to about 40°.

Although it has been described that the side walls of each second trench 600 include three sections having different inclination angles with respect to the bottom surface, the present disclosure is not limited thereto. The side walls of each second trench 600 may include two or more sections having different inclination angles with respect to the bottom surface. In other words, each second trench 600 may include k number of side walls extending from the bottom surface 610, wherein k may be a natural number equal to or greater than 2. The angle of the j-th side wall of a second trench 600 with respect to the bottom surface 610 of the second trench 600 may be different from the angle of the (j-1)-th side wall of the second trench 600 with respect to the bottom surface 610 of the second trench 600. In this case, j may be equal to or smaller than k. The angles of the k number of side walls of the second trench 600 with respect to the bottom surface 610 may gradually increase from the j-th side wall extending from the bottom surface 610 of the second trench 600 to the first side wall 621 positioned at the top of the second trench 600. For example, the angles between the sidewalls of the second trench 600 may increase until the angle θ21 of the first side wall 621 of the second trench 600 , such that each angle is greater than a proceeding angle and angle θ21 is within a range from the proceeding angle and to 90° (e.g., θ2k ≤ θ2(k-1) ≤ ... ≤ θ21 ≤ 90°).

The number of sections that constitute a side wall of each second trench 600 may be equal to the number of sections that constitute a side wall of the first trench 500, or may be different from that. In other words, k may be equal to n, or may be different from n.

The heights of the side walls 621, 622, and 623 of the second trench 600 may be different from one another. The height of each of the side walls 621, 622, and 623 may refer to the length of the corresponding side wall of the side walls 621, 622, and 623 from one end to the other end along a direction perpendicular to the first conductivity type substrate 110. In each second trench 600, the height h21 of the first side wall 621, the height h22 of the second side wall 622, and the height h23 of the third side wall 623 may be different from one another. In the drawings, it is shown that the height h22 of the second side wall 622 is relatively greater than the height h21 of the first side wall 621 and the height h23 of the third side wall 623; however, this is merely an example, and their heights may be variously changed.

The depth of the second trenches 600 may be greater than the depth of the first trench 500. The sum of the heights of the side walls 621, 622, and 623 of each second trench 600 (e.g., h21 + h22 + h23) may be greater than the sum of the heights of the side walls 521, 522, and 523 of the first trench 500 (e.g., h11 + h12 + h13). The bottom surfaces 610 of the second trenches 600 may be positioned at a level lower than that of the bottom surface 510 of the first trench 500. However, the present disclosure is not limited thereto, and the bottom surfaces 610 of the second trenches 600 may be positioned at a level substantially equal or similar to that of the bottom surface 510 of the first trench 500.

Hereinafter, the shapes of the gate electrode 150 and the second conductivity type doped well regions 133 will be described in more detail with reference to FIG. 3.

As shown in FIG. 3, the gate electrode 150 may have a lower surface 151, and an outer surface 150o that includes side surfaces 152, 153, and 154 extending from the lower surface 151. The outer surface 150o of the gate electrode 150 may further include an upper surface 155 facing the lower surface 151, and the side surfaces 152, 153, and 154 may connect the lower surface 151 and the upper surface 155. The lower surface 151 of the gate electrode 150 may face the bottom surface 510 of the first trench 500. The side surfaces 152, 153, and 154 of the gate electrode 150 may include a first side surface 152, a second side surface 153, and a third side surface 154. The first side surface 152 of the gate electrode 150 may extend from the upper surface 155 of the gate electrode 150, and may face the first side wall 521 of the first trench 500. The second side surface 153 of the gate electrode 150 may extend from the first side surface 152, and may be positioned between the first side surface 152 and the third side surface 154. The second side surface 153 of the gate electrode 150 may face the second side wall 522 of the first trench 500. The third side surface 154 of the gate electrode 150 may extend from the second side surface 153, and may be positioned between the second side surface 153 and the lower surface 151. The third side surface 154 of the gate electrode 150 may face the third side wall 523 of the first trench 500.

At least some of the angles of the side surfaces 152, 153, and 154 of the gate electrode 150 with respect to the lower surface 151 will be different from one another. For example, in the gate electrode 150, the angle θg1 of the first side surface 152 with respect to the lower surface 151, the angle θg2 of the second side surface 153 with respect to the lower surface 151, and the angle θg3 of the third side surface 154 with respect to the lower surface 151 may be different from one another. In the gate electrode 150, the angle θg1 of the first side surface 152 with respect to the lower surface 151 may be equal to or larger than the angle θg2 of the second side surface 153 with respect to the lower surface 151. In the gate electrode 150, the angle θg2 of the second side surface 153 with respect to the lower surface 151 may be equal to or larger than the angle θg3 of the third side surface 154 with respect to the lower surface 151. The angle θg1 of the first side surface 152 of the gate electrode 150 with respect to the lower surface 151 may be substantially equal or similar to the angle θ11 of the first side wall 521 of the first trench 500 with respect to the bottom surface 510. The angle θg1 of the first side surface 152 of the gate electrode 150 with respect to the lower surface 151 may be in a range from about 75° to about 90°. The angle θg2 of the second side surface 153 of the gate electrode 150 with respect to the lower surface 151 may be substantially equal or similar to the angle θ12 of the second side wall 522 of the first trench 500 with respect to the bottom surface 510. The angle θg2 of the second side surface 153 of the gate electrode 150 with respect to the lower surface 151 may be in a range from about 40° to about 75°. The angle θg3 of the third side surface 154 of the gate electrode 150 with respect to the lower surface 151 may be substantially equal or similar to the angle θ13 of the third side wall 523 of the first trench 500 with respect to the bottom surface 510. The angle θg3 of the third side surface 154 of the gate electrode 150 with respect to the lower surface 151 may be in a range from about 0° to about 40°.

Although it has been described above that the side surfaces of the gate electrode 150 include three sections having different inclination angles with respect to the lower surface, the present disclosure is not limited thereto. The side surfaces of the gate electrode 150 may include two or more sections having different inclination angles with respect to the lower surface and may, in at least some embodiments, have the same number of sidewalls and/or inclination angles as the first trench 500. In other words, in at least some embodiments, the gate electrode 150 may include n number of side surfaces extending from the lower surface 151, wherein n may be a natural number equal to or greater than 2. The angle of the m-th side surface of the gate electrode 150 with respect to the lower surface 151 of the gate electrode 150 may be different from the angle of the (m-1)-th side surface of the gate electrode 150 with respect to the lower surface 151 of the gate electrode 150. In this case, m may be equal to or smaller than n. The angles of the n number of side surfaces of the gate electrode 150 with respect to the lower surface 151 of the gate electrode 150 may gradually increase from the n-th side surface of the gate electrode 150 extending from the lower surface 151 to the first side surface 152 extending from the upper surface 155 of the gate electrode 150.

The shapes of side surfaces 152, 153, and 154 positioned on both sides of the gate electrode 150 with respect to the lower surface 151 may be symmetrical. First side surfaces 152 may be positioned on both sides of the gate electrode 150 with respect to the lower surface 151. Second side surfaces 153 may be positioned on both sides of the gate electrode 150 with respect to the lower surface 151. Third side surfaces 154 may be positioned on both sides of the gate electrode 150 with respect to the lower surface 151.

The heights of the side surfaces 152, 153, and 154 of the gate electrode 150 may be different from one another. The height of each of the side surfaces 152, 153, and 154 may refer to the length of the corresponding side surface of the side surfaces 152, 153, and 154 from one end to the other end along a direction perpendicular to the first conductivity type substrate 110. In the gate electrode 150, the height hg1 of the first side surface 152, the height hg2 of the second side surface 153, and the height hg3 of the third side surface 154 may be different from one another. For example, the height hg1 of the first side surface 152 may be greater than the height hg2 of the second side surface 153, and the height hg2 of the second side surface 153 may be greater than the height hg3 of the third side surface 154. However, this is merely an example, and the relationship of the height hg1 of the first side surface 152, the height hg2 of the second side surface 153, and the height hg3 of the third side surface 154 may be variously changed.

A second conductivity type doped well region 133 may have an inner bottom surface 133a, and an inner surface 133i that includes side surfaces 133b, 133c, and 133d extending from the inner bottom surface 133a. The inner surface 133i of the second conductivity type doped well region 133 may refer to a surface spaced apart from the bottom surface 610 and side walls 621, 622, and 623 of a second trench 600. The inner bottom surface 133a of the second conductivity type doped well region 133 may face the bottom surface 610 of the second trench 600. The side surfaces 133b, 133c, and 133d of the second conductivity type doped well region 133 may include a first side surface 133b, a second side surface 133c, and a third side surface 133d. The first side surface 133b of the second conductivity type doped well region 133 may abut a first conductivity type doped layer 137, and may face the first side wall 621 of the second trench 600. The second side surface 133c of the second conductivity type doped well region 133 may extend from the first side surface 133b, and may be positioned between the first side surface 133b and the third side surface 133d. The second side surface 133c of the second conductivity type doped well region 133 may face the second side wall 622 of the second trench 600. The third side surface 133d of the second conductivity type doped well region 133 may extend from the second side surface 133c, and may be positioned between the second side surface 133c and the inner bottom surface 133a. The second conductivity type doped well region 133 may face the third side wall 623 of the second trench 600.

The angles of the side surfaces 133b, 133c, and 133d of the second conductivity type doped well region 133 with respect to the inner bottom surface 133a may be different from one another. For example, the angle θw1 of the first side surface 133b of the second conductivity type doped well region 133 with respect to the inner bottom surface 133a, the angle θw2 of the second side surface 133c of the second conductivity type doped well region 133 with respect to the inner bottom surface 133a, and the angle θw3 of the third side surface 133d of the second conductivity type doped well region 133 with respect to the inner bottom surface 133a may be different from one another. The angle θw1 of the first side surface 133b of the second conductivity type doped well region 133 with respect to the inner bottom surface 133a may be equal to or larger than the angle θw2 of the second side surface 133c of the second conductivity type doped well region 133 with respect to the inner bottom surface 133a. The angle θw2 of the second side surface 133c of the second conductivity type doped well region 133 with respect to the inner bottom surface 133a may be equal to or larger than the angle θw3 of the third side surface 133d of the second conductivity type doped well region 133 with respect to the inner bottom surface 133a. The angle θw1 of the first side surface 133b of the second conductivity type doped well region 133 with respect to the inner bottom surface 133a may be substantially equal or similar to the angle Θ21 of the first side wall 621 of the second trench 600 with respect to the bottom surface 610. The angle θw1 of the first side surface 133b of the second conductivity type doped well region 133 with respect to the inner bottom surface 133a may be in a range from about 75° to about 90°. The angle θw2 of the second side surface 133c of the second conductivity type doped well region 133 with respect to the inner bottom surface 133a may be substantially equal or similar to the angle θ21 of the first side wall 621 of the second trench 600 with respect to the bottom surface 610. The angle θw2 of the second side surface 133c of the second conductivity type doped well region 133 with respect to the inner bottom surface 133a may be in a range from about 40° to about 75°. The angle θw3 of the third side surface 133d of the second conductivity type doped well region 133 with respect to the inner bottom surface 133a may be substantially equal or similar to the angle θ23 of the third side wall 623 of the second trench 600 with respect to the bottom surface 610. The angle θw3 of the third side surface 133d of the second conductivity type doped well region 133 with respect to the inner bottom surface 133a may be in a range from about 0° to about 40°.

Although it has been described above that the side surfaces of each second conductivity type doped well region 133 include three sections having different inclination angles with respect to the inner bottom surface, the present disclosure is not limited thereto. The side surfaces of each second conductivity type doped well region 133 may include two or more sections having different inclination angles with respect to the inner bottom surface. In other words, a second conductivity type doped well region 133 may include k number of side surfaces extending from the inner bottom surface 133a, wherein k may be a natural number equal to or greater than 2. The angle of the j-th side surface of the second conductivity type doped well region 133 with respect to the inner bottom surface 133a of the second conductivity type doped well region 133 may be different from the angle of (j-1)-th side surface of the second conductivity type doped well region 133 with respect to the inner bottom surface 133a of the second conductivity type doped well region 133. In this case, j may be equal to or smaller than k. The angles of the k number of side surfaces of the second conductivity type doped well region 133 with respect to the inner bottom surface 133a may gradually increase from the j-th side surface of the second conductivity type doped well region 133 extending from the inner bottom surface 133a to the first side surface 133b adjacent to a first conductivity type doped layer 137.

The heights of the side surfaces 133b, 133c, and 133d of the second conductivity type doped well region 133 may be different from one another. The height of each of the side surfaces 133b, 133c, and 133d may refer to the length of the corresponding side surface of the side surfaces 133b, 133c, and 133d from one end to the other end along a direction perpendicular to the first conductivity type substrate 110. In the second conductivity type doped well region 133, the height hw1 of the first side surface 133b, the height hw2 of the second side surface 133c, and the height hw3 of the third side surface 133d may be different from one another. For example, the height hw1 of the first side surface 133b may be greater than the height hw2 of the second side surface 133c, and the height hw2 of the second side surface 133c may be greater than the height hw3 of the third side surface 133d. However, this is merely an example, and the relationship of the height hw1 of the first side surface 133b, the height hw2 of the second side surface 133c, and the height hw3 of the third side surface 133d may be variously changed.

Referring to FIG. 4, in the semiconductor device according to the at least one example embodiment, a current flow may occur in the vertical direction from the source electrode 173 toward the drain electrode 175 in a gate-on state. The current may flow from the source electrode 173 to the drain electrode 175 through first conductivity type doped layers 137, the second conductivity type doped well regions 133, the first conductivity type epitaxial layer 131, and the first conductivity type substrate 110. The first conductivity type epitaxial layer 131 of the semiconductor device according to the at least one example embodiment may include the first trench 500, and the gate electrode 150 may be positioned inside the first trench 500. Therefore, it is possible to reduce the impedance of the semiconductor device and improve the switching characteristic. Further, by using vertical crystal planes with a low defect density, it is possible to increase the electron mobility, thereby reducing the impedance of the semiconductor device, and since the relatively thick gate insulating layer 140 is used, the electric field strength is relatively low in the on/off state, and thus it is possible to improve the reliability of the semiconductor device.

The first conductivity type epitaxial layer 131 of the semiconductor device according to the at least one example embodiment further includes the second trenches 600, and the second conductivity type doped well regions 133 are positioned inside the second trenches 600. Therefore, it is possible to prevent and/or mitigate an electric field from being concentrated on the corner portions of the first trench 500 where the bottom surface and the side surfaces are in contact with each other, and it is possible to improve the breakdown voltage of the semiconductor device, and it is possible to reduce the leakage current. In the semiconductor device according to the at least one example embodiment, the side walls of the first trench 500 and the second trenches 600 have the shapes in which the inclination angles increase with the distance from their bottom surfaces. Accordingly, it is possible to more effectively prevent and/or mitigate an electric field from being concentrated on the corner portions of the first trench 500 where the bottom surface and the side walls are in contact with each other. Accordingly, the breakdown voltage of the semiconductor device according to the at least one example embodiment can be further improved, and the leakage current may be further reduced.

The semiconductor device according to the at least one example embodiment may be an n-type field effect transistor (n-FET). However, the present disclosure is not limited thereto, and the semiconductor device according to the at least one example embodiment may be a p-type field effect transistor (p-FET). In this case, the first conductivity type substrate 110, the first conductivity type epitaxial layer 131, and the first conductivity type doped layers 137 may be doped p-type substrate and layers, and the second conductivity type doped well regions 133 may be n-type doped regions.

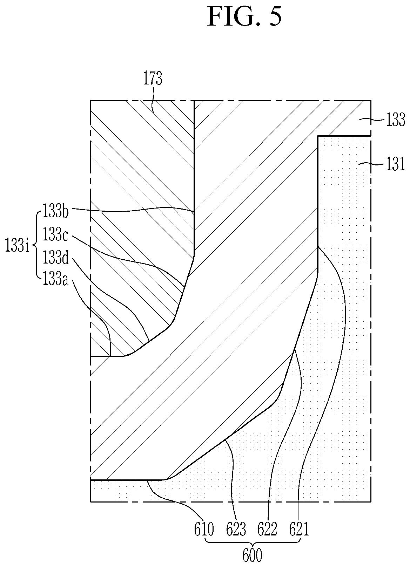

Now, semiconductor devices according to some example embodiments will be described with reference to FIGS. 5 to 9.

FIGS. 5 to 9 are cross-sectional views illustrating semiconductor devices according to some example embodiments.

FIGS. 5 to 9 show various modifications of the semiconductor device according to the at least one example embodiment shown in FIG. 1. The at least one example embodiments shown in FIGS. 5 to 9 have many portions identical to those of the at least one example embodiment shown in FIG. 1, and a description thereof will not be made, and the differences will be mainly described. Further, the constituent elements identical to those of the above example embodiment are denoted by the same reference symbols in the drawings. The at least one example embodiments shown in FIGS. 5 to 9 may be partially different from the above example embodiment in the shapes of the first trench or the second trenches and/or the like.

As shown in FIG. 5, the first conductivity type epitaxial layer 131 may include second trenches 600, and inside each second trench 600, a second conductivity type doped well region 133 and a source electrode 173 may be sequentially positioned.

A second trench 600 in the first conductivity type epitaxial layer 131 may have a bottom surface 610, and side walls 621, 622, and 623 extending from the bottom surface 610. In the above example embodiment, in each second trench 600, the connection portion between the first side wall 621 and the second side wall 622, the connection portion between the second side wall 622 and the third side wall 623, and the connection portion between the third side wall 623 and the bottom surface 610 may have angular shapes. In the present example embodiment, in each second trench 600, the connection portion between the first side wall 621 and the second side wall 622, the connection portion between the second side wall 622 and the third side wall 623, and the connection portion between the third side wall 623 and the bottom surface 610 may have round shapes. The connection portion of each second trench 600 between the first side wall 621 and the second side wall 622, the connection portion between the second side wall 622 and the third side wall 623, and the connection portion between the third side wall 623 and the bottom surface 610 may be formed so as to have angular shapes, and then be transformed to round shapes and/or the like during a high-temperature annealing process or the like. In this case, each connection portion may be transformed not only to a round shape but also to various other shapes. Alternatively, in each second trench 600, some of the connection portion between the first side wall 621 and the second side wall 622, the connection portion between the second side wall 622 and the third side wall 623, and the connection portion between the third side wall 623 and the bottom surface 610 may have round shapes.

The second conductivity type doped well region 133 may have an inner bottom surface 133a, and an inner surface 133i that includes side surfaces 133b, 133c, and 133d extending from the inner bottom surface 133a. In the above example embodiment, in each second conductivity type doped well region 133, the connection portion between the first side surface 133b and the second side surface 133c, the connection portion between the second side surface 133c and the third side surface 133d, and the connection portion between the third side surface 133d and the inner bottom surface 133a may have angular shapes. In the present example embodiment, the connection portion of each second conductivity type doped well region 133 between the first side surface 133b and the second side surface 133c, the connection portion between the second side surface 133c and the third side surface 133d, and the connection portion between the third side surface 133d and the inner bottom surface 133a may have round shapes. The shapes of the connection portions of the individual sections of the second conductivity type doped well region 133 may be influenced by the shapes of the connection portions of the individual sections of the second trench 600. For example, when the connection portions of the individual sections of the second trench 600 have round shapes, the connection portions of the individual sections of the second conductivity type doped well region 133 may have round shapes. In this case, each connection portion may be transformed not only to a round shape but also to have various other shapes. Alternatively, some of the connection portion of the second conductivity type doped well region 133 between the first side surface 133b and the second side surface 133c, the connection portion between the second side surface 133c and the third side surface 133d, and the connection portion between the third side surface 133d and the inner bottom surface 133a may have round shapes.

The first conductivity type epitaxial layer 131 may include a first trench (e.g., the reference symbol "500" in FIG. 1), and inside the first trench, a gate insulating layer (the reference symbol "140" in FIG. 1) and a gate electrode (the reference symbol "150" in FIG. 1) may be sequentially positioned. Although not shown in the drawing, similar to the second trenches 600 in the first conductivity type epitaxial layer 131, in the first trench 500 of the first conductivity type epitaxial layer 131, at least one of the connection portion between the bottom surface and a side wall and the connection portions between the side walls may have a round shape. Further, in the gate electrode, at least one of the connection portion between the lower surface and a side surface and the connection portions between the side surfaces may have a round shape.

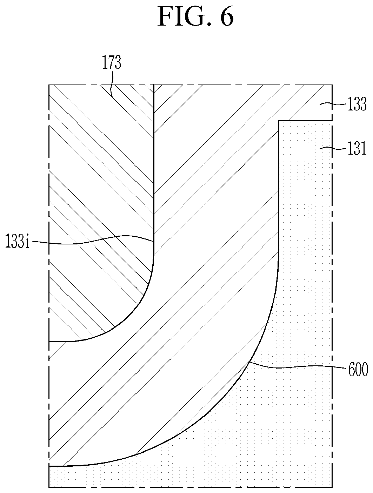

As shown in FIG. 6, the bottom surface and side surfaces of each second trench 600 of the first conductivity type epitaxial layer 131 may have a round shape as a whole without being distinguished from one another. This may be a result obtained by forming the second trenches 600 in the first conductivity type epitaxial layer 131 and then transforming the shape of the second trenches 600 during a high-temperature annealing process or the like. In this case, each second trench 600 may comprise a curved surface having a single curvature. In this case, the curvature radius of the curved surface of each second trench 600 may be variously changed. For example, the curvature radiuses of the second trenches 600 may be determined in consideration of the width, depth, and/or the like of the second trenches 600. However, the present disclosure is not limited thereto, each second trench 600 may be divided into two or more sections having different curvature radiuses.

According to this shape of the second trenches 600 of the first conductivity type epitaxial layer 131, the inner surface 133i of each second conductivity type doped well region 133 may have a round shape as a whole, and the inner bottom surface and the side surfaces may not be distinguished from one another. In this case, the inner surface 133i of each second conductivity type doped well region 133 may comprise a curved surface having a single curvature. However, the present disclosure is not limited thereto, and the inner surface 133i of each second conductivity type doped well region 133 may be divided into two or more sections having different curvature radiuses.

Although not shown in the drawing, similar to the second trenches 600 of the first conductivity type epitaxial layer 131, the bottom surface and side walls of the first trench of the first conductivity type epitaxial layer 131 may have a round shape as a whole without being distinguished from one another. Further, the lower surface and side surfaces of the gate electrode positioned inside the first trench may have a round shape as a whole without being distinguished from one another.

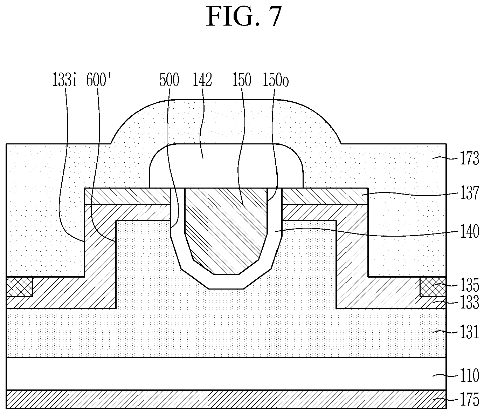

As shown in FIG. 7, the first conductivity type epitaxial layer 131 may include a first trench 500 and second trenches 600'.

Similar to the above example embodiment, in the present example embodiment, the side walls of the first trench 500 of the first conductivity type epitaxial layer 131 may have shapes in which the inclination angles increase with the distance from the bottom surface. Accordingly, the side surfaces of the gate electrode 150 that is positioned inside the first trench 500 may have shapes in which the inclination angles increase with the distance from the lower surface.

Unlike the above example embodiment, in the present example embodiment, the inclination angles of the side walls of the second trenches 600' of the first conductivity type epitaxial layer 131 may be constant. In other words, the side walls of the second trenches 600' may have a single inclination angle, rather than various inclination angles. For example, the angles of the side surfaces of the second trenches 600' with respect to the bottom surfaces may be about 90°. However, this is merely an example, and the angles of the side surfaces of the second trenches 600 with respect to the bottom surfaces may be variously changed and/or greater than or less than 90°. Accordingly, the inclination angles of the side surfaces of the second conductivity type doped well regions 133 that are positioned inside the second trenches 600' may be constant. In other words, the side surfaces of the second conductivity type doped well regions 133 may have a single inclination angle, rather than various inclination angles. For example, the angles of the side surfaces of the second conductivity type doped well regions 133 with respect to the inner bottom surfaces may be about 90°. However, this is merely an example, and the angles of the side surfaces of the second conductivity type doped well regions 133 with respect to the inner bottom surfaces may be variously changed.

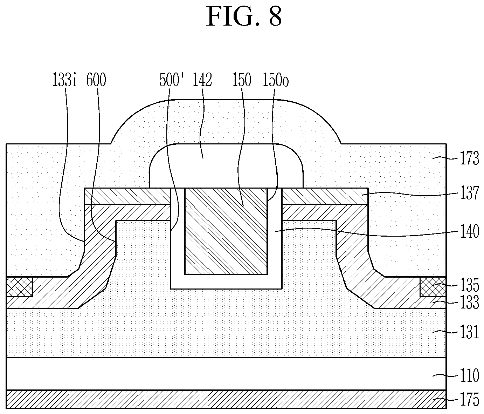

As shown in FIG. 8, in the present example embodiment, the side walls of each second trench 600 of the first conductivity type epitaxial layer 131 may have a shape in which the inclination angles increase with the distance from the bottom surface. Accordingly, the side surfaces of each second conductivity type doped well region 133 that is positioned inside a second trench 600 may have a shape in which the inclination angles increase with the distance from the inner bottom surface.

In the present example embodiment, the inclination angles of the side walls of the first trench 500' of the first conductivity type epitaxial layer 131 may be constant. In other words, the side walls of the first trench 500' may have a single inclination angle, rather than various inclination angles. For example, the angles of the side walls of the first trench 500' with respect to the bottom surface may be about 90°. However, this is merely an example, and the angles of the side walls of the first trench 500' with respect to the bottom surface may be variously changed. Accordingly, the inclination angles of the side surfaces of the gate electrode 150 that is positioned inside the first trench 500' may be constant. In other words, the side surfaces of the gate electrode 150 may have a single inclination angle, rather than various inclination angles. For example, the angles of the side surfaces of the gate electrode 150 with respect to the lower surface may be about 90°. However, this is merely an example, and the angles of the side surfaces of the gate electrode 150 with respect to the lower surface may be variously changed.

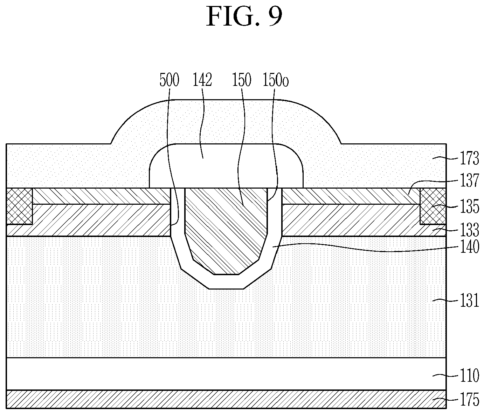

As shown in FIG. 9, the first conductivity type epitaxial layer 131 may include a first trench 500. Unlike the above example embodiment, the first conductivity type epitaxial layer 131 may not include any second trenches. Second conductivity type doped well regions 133 may be positioned on the flat upper surface of the first conductivity type epitaxial layer 131. Accordingly, the upper surfaces of the second conductivity type doped well regions 133 may not have certain inclination angles, but may have flat shapes. In other words, the second conductivity type doped well regions 133 may have flat lower surfaces and flat upper surfaces.

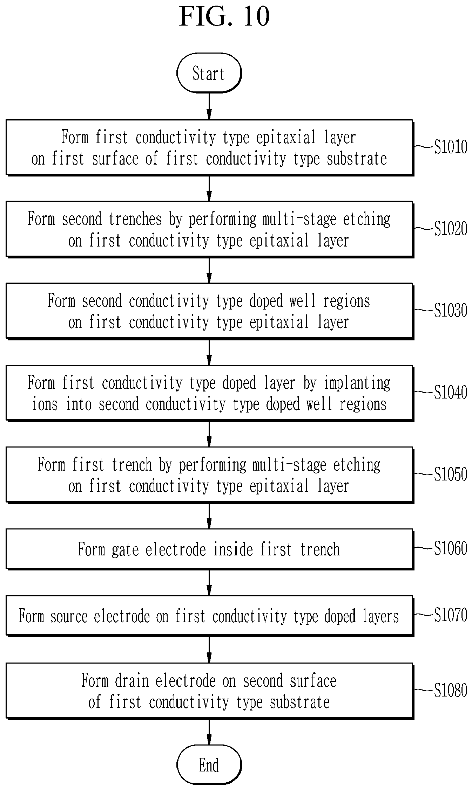

Subsequently, a method of manufacturing a semiconductor device according to at least one example embodiment will be described with reference to FIGS. 10 to 21.

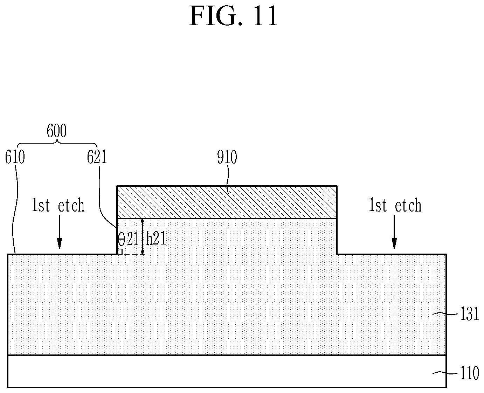

FIG. 10 is a flow chart illustrating a method of manufacturing a semiconductor device according to at least one example embodiment, and FIGS. 11 to 21 are cross-sectional views illustrating processes of the method of manufacturing the semiconductor device according to the at least one example embodiment in the order of the processes.

As shown in FIG. 11, on a first conductivity type substrate 110, a first conductivity type epitaxial layer 131 may be formed (S1010), and second trenches 600 may be formed by performing etching on the first conductivity type epitaxial layer 131 (S1020).

The first conductivity type substrate 110 may be a semiconductor substrate containing SiC. For example, the first conductivity type substrate 110 may include a 4H SiC substrate. The first conductivity type substrate 110 may be a highly n-type doped substrate. The first conductivity type substrate 110 may have the first surface and the second surface facing each other. The first surface of the first conductivity type substrate 110 may be the upper surface, and the second surface of the first conductivity type substrate 110 may be the lower surface.

The first conductivity type epitaxial layer 131 may be formed on the first surface of the first conductivity type substrate 110, e.g., the upper surface by an epitaxial growth method. The first conductivity type epitaxial layer 131 may be formed directly on the first conductivity type substrate 110, or other predetermined layers may be formed on the first conductivity type substrate 110 and then the first conductivity type epitaxial layer 131 may be formed thereon. The first conductivity type epitaxial layer 131 may contain SiC. For example, the first conductivity type epitaxial layer 131 may contain 4H SiC. The first conductivity type epitaxial layer 131 may be a lowly n-type doped layer. The doping type of the first conductivity type epitaxial layer 131 may be the same as the doping type of the first conductivity type substrate 110. The dopant of the first conductivity type epitaxial layer 131 may be the same as the dopant of the first conductivity type substrate 110, or may be different from that. The doping concentration of the first conductivity type epitaxial layer 131 may be lower than the doping concentration of the first conductivity type substrate 110.

On the first conductivity type epitaxial layer 131, a first mask pattern 910 may be formed, and the second trenches 600 may be formed by performing etching on the first conductivity type epitaxial layer 131 using the first mask pattern 910.

For example, on the first conductivity type epitaxial layer 131, a hard mask layer and a photoresist layer may be sequentially formed. The photoresist layer may be patterned by a photolithography process to form a photoresist pattern. Etching may be performed on the hard mask layer, using the photoresist pattern as a mask. In this way, the first mask pattern 910 may be formed.

When a first etching process (1st etch) of performing etching on the first conductivity type epitaxial layer 131 using the first mask pattern 910 is performed, the portions of the first conductivity type epitaxial layer 131 exposed to the outside without being covered by the first mask pattern 910 are etched such that their thickness is reduced, and the portions of the first conductivity type epitaxial layer 131 covered by the first mask pattern 910 remain the same. The portions from which the first conductivity type epitaxial layer 131 has been removed may become the second trenches 600. The first etching process (1st etch) for forming the second trenches 600 may include a dry etching process. However, the first etching process (1st etch) is not limited thereto and may include a wet etching process and/or the like.

Each second trench 600 formed by the first etching process (1st etch) may include a bottom surface 610 and a first side wall 621 extending from the bottom surface 610. The first side wall 621 of each second trench 600 may connect the bottom surface 610 of the second trench 600 and the upper surface of the first conductivity type epitaxial layer 131 covered by the first mask pattern 910. Depending on the process conditions of the first etching process (1st etch), the angle θ21 of the first side wall 621 of the second trench 600 with respect to the bottom surface 610, the height h21 of the first side wall 621 of the second trench 600, and/or the like may be determined. For example, the angle θ21 of the first side wall 621 of the second trench 600 with respect to the bottom surface 610 may be adjusted by appropriately selecting an ambient gas to be used in the first etching process (1st etch). The angle θ21 of the first side wall 621 of the second trench 600 with respect to the bottom surface 610 may be in a range from about 75° to about 90°. Further, the height h21 of the first side wall 621 of the second trench 600 may be adjusted by appropriately selecting the time for which the first etching process (1st etch) should be performed.

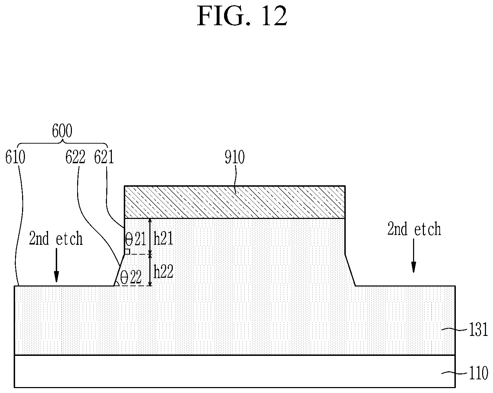

As shown in FIG. 12, a second etching process (2nd etch) of performing etching on the first conductivity type epitaxial layer 131 using the first mask pattern 910 may be performed. The depth of the second trenches 600 may be increased by the second etching process (2nd etch). The second etching process (2nd etch) may include a dry etching process. However, the second etching process (2nd etch) is not limited thereto, and may include a wet etching process and/or the like.

The process conditions of the second etching process (2nd etch) may be different from the process conditions of the first etching process (1st etch) performed before. Due to the difference in the process conditions between the first etching process (1st etch) and the process conditions of the second etching process (2nd etch), the side walls of each second trench 600 may be configured to include a plurality of sections having different inclination angles. Each second trench 600 may further include a second side wall 622 that connects the bottom surface 610 and the first side wall 621. The angle θ22 of the second side wall 622 of each second trench 600 with respect to the bottom surface 610 may be adjusted by appropriately selecting an ambient gas to be used in the second etching process (2nd etch). For example, an ambient gas may be selected such that the amount of etch byproduct and/or inhibitor increases in the second etching process (2nd etch). In each second trench 600, the angle θ21 of the first side wall 621 with respect to the bottom surface 610 may be different from the angle θ22 of the second side wall 622 with respect to the bottom surface 610. In each second trench 600, the angle θ21 of the first side wall 621 with respect to the bottom surface 610 may be equal to or greater than the angle θ22 of the second side wall 622 with respect to the bottom surface 610. The angle θ22 of the second side wall 622 of the second trench 600 with respect to the bottom surface 610 may be in a range from about 40° to about 75°. Further, the height h22 of the second side wall 622 of each second trench 600 may be adjusted by appropriately selecting the time for which the second etching process (2nd etch) should be performed.

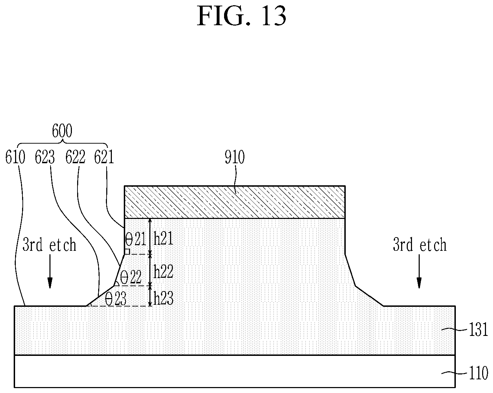

As shown in FIG. 13, a third etching process (3rd etch) of performing etching on the first conductivity type epitaxial layer 131 using the first mask pattern 910 may be performed. The depth of the second trenches 600 may be further increased by the third etching process (3rd etch). The third etching process (3rd etch) may include a dry etching process. However, the third etching process (3rd etch) is not limited thereto, and may include a wet etching process and/or the like.

The process conditions of the third etching process (3rd etch) may be different from the process conditions of the first etching process (1st etch) and/or the second etching process (2nd etch) performed before. Due to the differences in the process conditions of the first etching process (1st etch), the second etching process (2nd etch), and the third etching process (3rd etch), the side walls of each second trench 600 may be configured to include a plurality of sections having different inclination angles. Each second trench 600 may further include a third side wall 623 that connects the bottom surface 610 and the second side wall 622. The angle θ23 of the third side wall 623 of each second trench 600 with respect to the bottom surface 610 may be adjusted by appropriately selecting an ambient gas to be used in the third etching process (3rd etch). For example, an ambient gas may be selected such that the amount of etch byproduct and/or inhibitor further increases in the third etching process (3rd etch). In each second trench 600, the angle θ22 of the second side wall 622 with respect to the bottom surface 610 may be different from the angle θ23 of the third side wall 623 with respect to the bottom surface 610. In each second trench 600, the angle θ22 of the second side wall 622 with respect to the bottom surface 610 may be equal to or greater than the angle θ23 of the third side wall 623 with respect to the bottom surface 610. The angle θ23 of the third side wall 623 of the second trench 600 with respect to the bottom surface 610 may be in a range from about 0° to about 40°. Further, the height h23 of the third side wall 623 of each second trench 600 may be adjusted by appropriately selecting the time for which the third etching process (3rd etch) should be performed.

According to the method of manufacturing the semiconductor device according to the at least one example embodiment, an etching process including multiple stages having different process conditions, for example, the first etching process (1st etch), the second etching process (2nd etch), and the third etching process (3rd etch) may be performed to form the second trenches 600. Accordingly, the angles of the side walls 621, 622, and 623 of each second trench 600 with respect to the bottom surface 610 may be different from one another. Although it has been described above that the multi-stage etching process may include three etching processes different in their process conditions, the present disclosure is not limited thereto. The number of processes that constitute the multi-stage etching process may be, e.g., two, and/or may be four or greater. Similarly, although it has been described that the side walls of each second trench 600 include three sections having different inclination angles with respect to the bottom surface, the present disclosure is not limited thereto. The side walls of each second trench 600 may include two or more sections having different inclination angles with respect to the bottom surface. In other words, each second trench 600 may include k number of side walls extending from the bottom surface 610, wherein k be a natural number equal to or greater than 2. The angle of the j-th side wall of a second trench 600 with respect to the bottom surface 610 of the second trench 600 may be different from the angle of the (j-1)-th side wall of the second trench 600 with respect to the bottom surface 610 of the second trench 600. In this case, j may be equal to or smaller than k. The angles of the k number of side walls of the second trench 600 with respect to the bottom surface 610 may gradually increase from the j-th side wall extending from the bottom surface 610 of the second trench 600 to the first side wall 621 positioned at the top of the second trench 600.

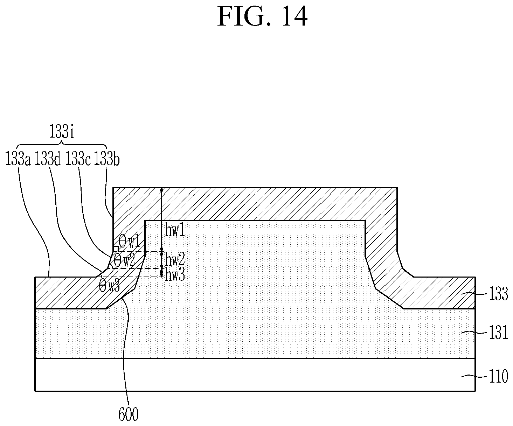

As shown in FIG. 14, the first mask pattern 910 may be removed, and second conductivity type doped well regions 133 may be formed on the first conductivity type epitaxial layer 131 (S1030).

The second conductivity type doped well regions 133 may be formed on the first conductivity type epitaxial layer 131 by an epitaxial growth method. The second conductivity type doped well regions 133 may be formed directly on the first conductivity type epitaxial layer 131, and/or other layers may be formed on the first conductivity type epitaxial layer 131 and then the second conductivity type doped well regions 133 may be formed thereon. The second conductivity type doped well regions 133 may contain SiC. For example, the second conductivity type doped well regions 133 may contain 4H SiC. The second conductivity type doped well regions 133 may be a lowly doped p-type regions. The doping type of the second conductivity type doped well regions 133 may be different from the doping type of the first conductivity type epitaxial layer 131.

The second conductivity type doped well regions 133 may be formed on the first conductivity type epitaxial layer 131 so as to conform to the first conductivity type epitaxial layer. Accordingly, the portions of the second conductivity type doped well regions 133 that are positioned in the second trenches 600 of the first conductivity type epitaxial layer 131 may be formed so as to have substantially U-shaped cross sections according to the shapes of the second trenches 600. In the drawings, only some portions of the second conductivity type doped well regions 133 having a U shape are shown. The second conductivity type doped well regions 133 may be formed on the bottom surfaces and side surfaces of the second trenches 600 so as to conform thereto. Accordingly, the entire second trenches 600 may not be filled by the second conductivity type doped well regions 133. One surface of each second conductivity type doped well region 133 abutting the first conductivity type epitaxial layer 131 inside a second trench 600 may have substantially the same cross-sectional shape as that of the corresponding second trench 600. The opposite surface of each second conductivity type doped well region 133 abutting the source electrode 173 inside a second trench 600 may have a cross-sectional shape similar to that of the corresponding second trench 600.

A second conductivity type doped well region 133 may have an inner bottom surface 133a, and an inner surface 133i that includes side surfaces 133b, 133c, and 133d extending from the inner bottom surface 133a. The inner bottom surface 133a of the second conductivity type doped well region 133 may face the bottom surface 610 of the second trench 600. The side surfaces 133b, 133c, and 133d of the second conductivity type doped well region 133 may include a first side surface 133b, a second side surface 133c, and a third side surface 133d. The angles of the side surfaces 133b, 133c, and 133d of the second conductivity type doped well region 133 with respect to the inner bottom surface 133a may be different from one another. The angle θw1 of the first side surface 133b of the second conductivity type doped well region 133 with respect to the inner bottom surface 133a may be equal to or larger than the angle θw2 of the second side surface 133c of the second conductivity type doped well region 133 with respect to the inner bottom surface 133a. The angle θw2 of the second side surface 133c of the second conductivity type doped well region 133 with respect to the inner bottom surface 133a may be equal to or larger than the angle θw3 of the third side surface 133d of the second conductivity type doped well region 133 with respect to the inner bottom surface 133a.

Although it has been described above that the side surfaces of each second conductivity type doped well region 133 include three sections having different inclination angles with respect to the inner bottom surface, the present disclosure is not limited thereto. The side surfaces of each second conductivity type doped well region 133 may include two or more sections having different inclination angles with respect to the inner bottom surface. In other words, a second conductivity type doped well region 133 may include k number of side surfaces extending from the inner bottom surface 133a, wherein k may be a natural number equal to or greater than 2. The angle of the j-th side surface of the second conductivity type doped well region 133 with respect to the inner bottom surface 133a of the second conductivity type doped well region 133 may be different from the angle of (j-1)-th side surface of the second conductivity type doped well region 133 with respect to the inner bottom surface 133a of the second conductivity type doped well region 133. In this case, j may be equal to or smaller than k. The angles of the k number of side surfaces of the second conductivity type doped well region 133 with respect to the inner bottom surface 133a may gradually increase from the j-th side surface of the second conductivity type doped well region 133 extending from the inner bottom surface 133a to the first side surface 133b adjacent to a first conductivity type doped layer 137.

The heights of the side surfaces 133b, 133c, and 133d of the second conductivity type doped well region 133 may be different from one another.

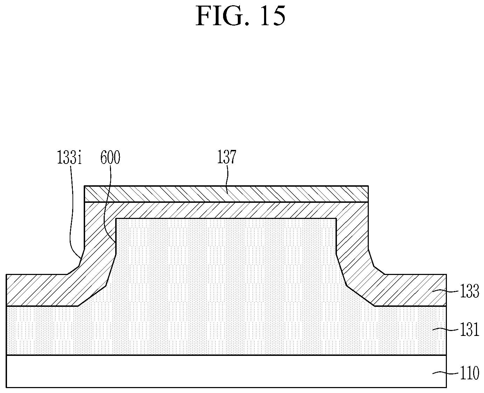

As shown in FIG. 15, a first conductivity type doped layer 137 may be formed by implanting ions into the second conductivity type doped well regions 133 (S1040).

The first conductivity type doped layer 137 may be formed in the second conductivity type doped well regions 133 by an ion implantation process (IIP). The first conductivity type doped layer 137 may be formed in at least some portions of the second conductivity type doped well regions 133. For example, the first conductivity type doped layer 137 may be formed from the upper surfaces of the second conductivity type doped well regions 133 to a predetermined depth. In this case, the first conductivity type doped layer 137 may not be formed in the portions of the second conductivity type doped well regions 133 positioned inside the second trenches 600. The first conductivity type doped layer 137 may vertically overlap the region between two second trenches 600 facing each other.

The first conductivity type doped layer 137 may contain SiC. For example, the first conductivity type doped layer 137 may contain 4H SiC. The first conductivity type doped layer 137 may be highly n-type doped layers. The doping type of the first conductivity type doped layer 137 may be different from the doping type of the second conductivity type doped well regions 133. The doping type of the first conductivity type doped layer 137 may be the same as the doping type of the first conductivity type substrate 110 and the first conductivity type epitaxial layer 131. The dopant of the first conductivity type doped layer 137 may be the same as the dopant of the first conductivity type substrate 110 and/or the first conductivity type epitaxial layer 131, or may be different from that.

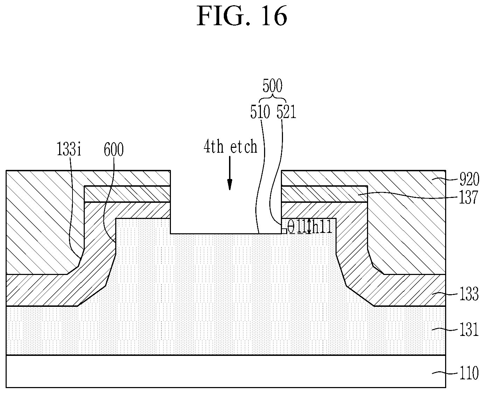

As shown in FIG. 16, a first trench 500 may be formed by performing etching on the first conductivity type epitaxial layer 131 (S1050).

A second mask pattern 920 may be formed on the first conductivity type epitaxial layer 131, the second conductivity type doped well regions 133, and the first conductivity type doped layer 137, and the first trench 500 may be formed by sequentially performing etching on the first conductivity type doped layer 137, the second conductivity type doped well regions 133, and the first conductivity type epitaxial layer 131 using the second mask pattern 920. When a fourth etching process (4th etch) of performing etching the first conductivity type doped layer 137, the second conductivity type doped well regions 133, and the first conductivity type epitaxial layer 131 using the second mask pattern 920 is performed, the portions of the first conductivity type doped layer 137 exposed to the outside without being covered by the second mask pattern 920 are removed, and the portions of the first conductivity type doped layer 137 covered by the second mask pattern 920 remain the same. As a portion of the first conductivity type doped layer 137 is removed, at least some portions of the second conductivity type doped well regions 133 positioned below the first conductivity type doped layer 137 may be exposed to the outside. Subsequently, the exposed portions of the second conductivity type doped well regions 133 may be removed. As the portions of the second conductivity type doped well regions 133 are removed, at least a portion of the first conductivity type epitaxial layer 131 positioned below the second conductivity type doped well regions 133 may be exposed to the outside. Subsequently, the exposed portion of the first conductivity type epitaxial layer 131 may be etched such that the thickness decreases. The portion from which the first conductivity type epitaxial layer 131 has been removed may become the first trench 500. The fourth etching process (4th etch) may include a dry etching process, but is not limited thereto.

The first trench 500 formed by the fourth etching process (4th etch) may have a bottom surface 510 and a first side wall 521 extending from the bottom surface 510. The first side wall 521 of the first trench 500 may connect the bottom surface 510 of the first trench 500 and the upper surface of the first conductivity type epitaxial layer 131 covered by the second mask pattern 920. Depending on the process conditions of the fourth etching process (4th etch), the angle θ11 of the first side wall 521 of the first trench 500 with respect to the bottom surface 510, the height h 11 of the first side wall 521 of the first trench 500, and/or the like may be determined. For example, the angle θ11 of the first side wall 521 of the first trench 500 with respect to the bottom surface 510 may be adjusted by appropriately selecting an ambient gas to be used in the fourth etching process (4th etch). The angle θ11 of the first side wall 521 of the first trench 500 with respect to the bottom surface 510 may be in a range from about 75° to about 90°. Further, the height h 11 of the first side wall 521 of the first trench 500 may be adjusted by appropriately selecting the time for which the fourth etching process (4th etch) should be performed.

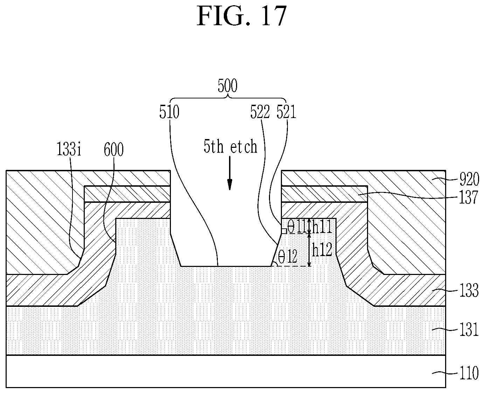

As shown in FIG. 17, a fifth etching process (5th etch) of performing etching on the first conductivity type epitaxial layer 131 using the second mask pattern 920 may be performed. The depth of the first trench 500 may be increased by the fifth etching process (5th etch). The fifth etching process (5th etch) may include a dry etching process, but is not limited thereto.

The process conditions of the fifth etching process (5th etch) may be different from the process conditions of the fourth etching process (4th etch) performed before. Due to the difference in the process conditions between the fourth etching process (4th etch) and the fifth etching process (5th etch), the side walls of the first trench 500 may be configured to include a plurality of sections having different inclination angles. The first trench 500 may further include a second side wall 522 that connects the bottom surface 510 and the first side wall 521. The angle θ12 of the second side wall 522 of the first trench 500 with respect to the bottom surface 510 may be adjusted by appropriately selecting an ambient gas to be used in the fifth etching process (5th etch). For example, an ambient gas may be selected such that the amount of etch byproduct and/or inhibitor increases in the fifth etching process (5th etch). In the first trench 500, the angle θ11 of the first side wall 521 with respect to the bottom surface 510 may be different from the angle θ12 of the second side wall 522 with respect to the bottom surface 510. In the first trench 500, the angle θ11 of the first side wall 521 with respect to the bottom surface 510 may be equal to or larger than the angle θ12 of the second side wall 522 with respect to the bottom surface 510. The angle θ12 of the second side wall 522 of the first trench 500 with respect to the bottom surface 510 may be in a range from about 40° to about 75°. Further, the height h12 of the second side wall 522 of the first trench 500 may be adjusted by appropriately selecting the time for which the fifth etching process (5th etch) should be performed.

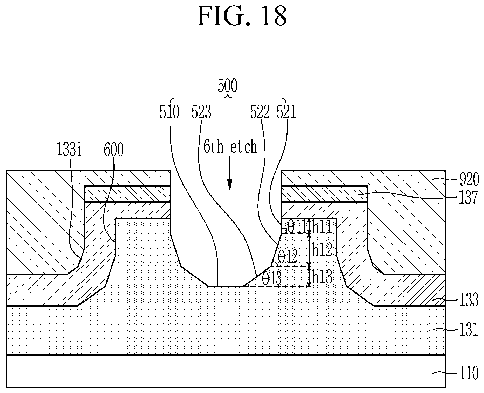

As shown in FIG. 18, a sixth etching process (6th etch) of performing etching on the first conductivity type epitaxial layer 131 using the second mask pattern 920 may be performed. The depth of the first trench 500 may be further increased by the sixth etching process (6th etch). The sixth etching process (6th etch) may include a dry etching process, but is not limited thereto.

The process conditions of the sixth etching process (6th etch) may be different from the process conditions of the fourth etching process (4th etch) and/or the fifth etching process (5th etch) performed before. Due to the differences in the process conditions of the fourth etching process (4th etch), the fifth etching process (5th etch), and the sixth etching process (6th etch), the side walls of the first trench 500 may be configured to include a plurality of sections having different inclination angles. The first trench 500 may further include a third side wall 523 that connects the bottom surface 510 and the second side wall 522. The angle θ13 of the third side wall 523 of the first trench 500 with respect to the bottom surface 510 may be adjusted by appropriately selecting an ambient gas to be used in the sixth etching process (6th etch). For example, an ambient gas may be selected such that the amount of etch byproduct and/or inhibitor further increases in the sixth etching process (6th etch). In the first trench 500, the angle θ12 of the second side wall 522 with respect to the bottom surface 510 may be different from the angle θ23 of the third side wall 523 with respect to the bottom surface 510. In the first trench 500, the angle θ12 of the second side wall 522 with respect to the bottom surface 510 may be equal to or larger than the angle θ13 of the third side wall 523 with respect to the bottom surface 510. The angle θ13 of the third side wall 523 of the first trench 500 with respect to the bottom surface 510 may be in a range from about 0° to about 40°. Further, the height h13 of the third side wall 523 of the first trench 500 may be adjusted by appropriately selecting the time for which the sixth etching process (6th etch) should be performed.

According to the method of manufacturing the semiconductor device according to the at least one example embodiment, an etching process including multiple stages having different process conditions, for example, the fourth etching process (4th etch), the fifth etching process (5th etch), and the sixth etching process (6th etch) may be performed to form the first trench 500. Accordingly, the angles of the side walls 521, 522, and 523 of the first trench 500 with respect to the bottom surface 510 may be different from one another. Although it has been described above that the multi-stage etching process may include three etching processes different in their process conditions, the present disclosure is not limited thereto. The number of processes that constitute the multi-stage etching process may be two, or may be four or greater. Similarly, although it has been described that the side walls of the first trench 500 includes three sections having different inclination angles with respect to the bottom surface, the present disclosure is not limited thereto. The side walls of the first trench 500 may include two or more sections having different inclination angles with respect to the bottom surface. In other words, the first trench 500 may include n number of side walls extending from the bottom surface 510, wherein n may be a natural number equal to or greater than 2. The angle of the m-th side wall of the first trench 500 with respect to the bottom surface 510 of the first trench 500 may be different from the angle of the (m-1)-th side wall of the first trench 500 with respect to the bottom surface 510 of the first trench 500. In this case, m may be equal to or smaller than n. The angles of the n number of side walls of the first trench 500 with respect to the bottom surface 510 may gradually increase from the n-th side wall extending from the bottom surface 510 of the first trench 500 extending from the bottom surface 510 to the first side wall 521 positioned at the top of the first trench 500.

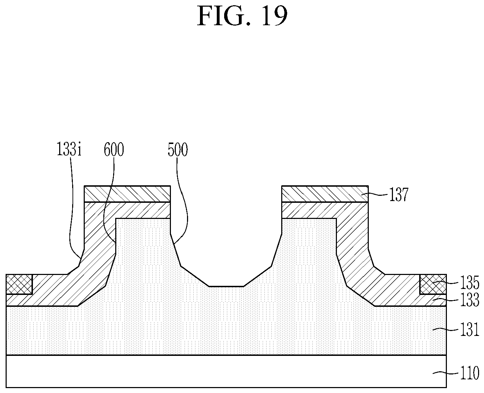

As shown in FIG. 19, the second mask pattern 920 may be removed, and the second conductivity type doped layers 135 may be further formed in the second conductivity type doped well regions 133.

The second conductivity type doped layers 135 may be formed in the second conductivity type doped well regions 133 by an ion implantation process. The second conductivity type doped layers 135 may be formed in at least some portions of the second conductivity type doped well regions 133. For example, the second conductivity type doped layers 135 may be formed from the inner bottom surfaces of the second conductivity type doped well regions 133 to a predetermined depth. The second conductivity type doped layers 135 may be positioned inside the second trenches 600.

The second conductivity type doped layers 135 may contain SiC. For example, the second conductivity type doped layers 135 may contain 4H SiC. The second conductivity type doped layers 135 may be highly doped p-type layers. The doping type of the second conductivity type doped layers 135 may be the same as the doping type of the second conductivity type doped well regions 133. The dopant of the second conductivity type doped layers 135 may be the same as the dopant of the second conductivity type doped well regions 133, or may be different from that. The doping concentration of the second conductivity type doped layers 135 may be higher than the doping concentration of the second conductivity type doped well regions 133.

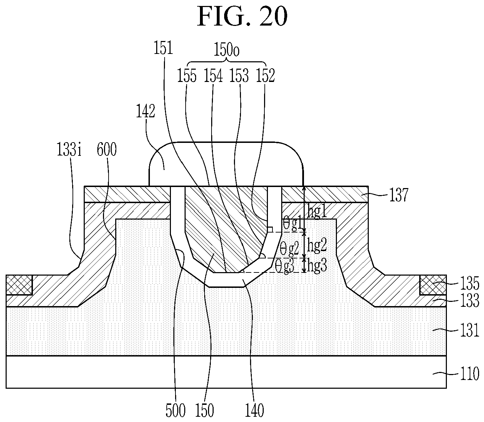

As shown in FIG. 20, a gate electrode 150 may be formed inside the first trench 500 (S1060).

First, when a high-temperature oxidation process is performed on the inside of the first trench 500, at least a portion of the first conductivity type epitaxial layer 131 constituting the bottom surface and side walls of the first trench 500 may be oxidized, whereby a gate insulating layer 140 may be formed. At this time, the side surfaces of the second conductivity type doped well regions 133 and the first conductivity type doped layers 137 adjacent to the first trench 500 of the first conductivity type epitaxial layer 131 may also be oxidized so as to constitute the gate insulating layer 140. Therefore, the gate insulating layer 140 may contain, e.g., SiO₂ in cases where in the first conductivity type epitaxial layer 131 includes SiC.

Subsequently, a gate material layer may be formed by depositing polysilicon on the gate insulating layer 140, the first conductivity type doped layers 137, the second conductivity type doped well regions 133, and the second conductivity type doped layers 135. The gate material layer may be patterned such that the gate material layer remains inside the first trench 500. In other words, only the portion of the gate material layer positioned on the gate insulating layer 140 may remain. At this time, the gate material layer may fill the first trench 500, and may have a thickness larger than the depth of the first trench 500.

The gate electrode 150 may be surrounded by the gate insulating layer 140. The gate electrode 150 may be spaced apart from the first conductivity type epitaxial layer 131 by the gate insulating layer 140. The gate electrode 150 may have a cross-sectional shape similar to that of the first trench 500. The lower surface and side surfaces of the gate electrode 150 may form an appropriate U shape conforming to the shape of the first trench 500 as seen in a cross-sectional view. In this case, the gate electrode 150 may contain polysilicon. However, the formation methods, materials, and/or the like of the gate electrode 150 and the gate insulating layer 140 are not limited thereto, and may be variously changed.

The gate electrode 150 may have a lower surface 151, side surfaces 152, 153, and 154 extending from the lower surface 151, and an outer surface 150o including an upper surface 155 facing the lower surface 151. The lower surface 151 of the gate electrode 150 may face the bottom surface 510 of the first trench 500. The side surfaces 152, 153, and 154 of the gate electrode 150 may include a first side surface 152, a second side surface 153, and a third side surface 154. The angles of the side surfaces 152, 153, and 154 of the gate electrode 150 with respect to the lower surface 151 may be different from one another. In the gate electrode 150, the angle θg1 of the first side surface 152 with respect to the lower surface 151 may be equal to or larger than the angle θg2 of the second side surface 153 with respect to the lower surface 151. In the gate electrode 150, the angle θg2 of the second side surface 153 with respect to the lower surface 151 may be equal to or larger than the angle θg3 of the third side surface 154 with respect to the lower surface 151.

Although it has been described above that the side surfaces of the gate electrode 150 include three sections having different inclination angles with respect to the lower surface, the present disclosure is not limited thereto. The side surfaces of the gate electrode 150 may include two or more sections having different inclination angles with respect to the lower surface. In other words, the gate electrode 150 may include n number of side surfaces extending from the lower surface 151, wherein n may be a natural number equal to or greater than 2. The angle of the m-th side surface of the gate electrode 150 with respect to the lower surface 151 of the gate electrode 150 may be different from the angle of the (m-1)-th side surface of the gate electrode 150 with respect to the lower surface 151 of the gate electrode 150. In this case, m may be equal to or smaller than n. The angles of the n number of side surfaces of the gate electrode 150 with respect to the lower surface 151 of the gate electrode 150 may gradually increase from the n-th side surface of the gate electrode 150 extending from the lower surface 151 to the first side surface 152 extending from the upper surface 155 of the gate electrode 150.

The heights of the side surfaces 152, 153, and 154 of the gate electrode 150 may be different from one another.

Subsequently, a capping layer 142 may be formed by depositing an insulating material on the gate electrode 150, the gate insulating layer 140, the first conductivity type doped layers 137, the second conductivity type doped well regions 133, and the second conductivity type doped layers 135 and patterning it. The capping layer 142 may cover the upper surface of the gate electrode 150. Further, the capping layer 142 may cover the gate insulating layer 140 and at least some portions of the first conductivity type doped layers 137 adjacent to the gate electrode 150.

The capping layer 142 may contain an insulating material. For example, the capping layer 142 may contain SiO₂. However, the material of the capping layer 142 is not limited thereto, and may be variously changed. As another example, the capping layer 142 may contain at least one of SiN, SiON, SiCN, or a combination thereof. However, the formation method, material, and/or the like of the capping layer 142 are not limited thereto, and may be variously changed.

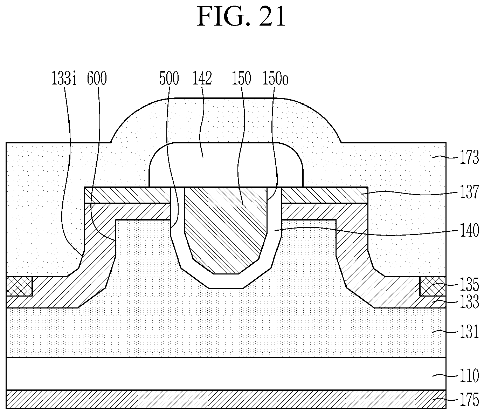

As shown in FIG. 21, a source electrode 173 may be formed on the first conductivity type doped layers 137 (S1070), and a drain electrode 175 may be formed on the second surface of the first conductivity type substrate 110 (S1080).

The source electrode 173 may be formed by depositing a conductive material on the capping layer 142, the first conductivity type doped layers 137, the second conductivity type doped well regions 133, and the second conductivity type doped layers 135 and patterning it. The source electrode 173 may be electrically insulated from the gate electrode 150 by the capping layer 142. The source electrode 173 may abut the first conductivity type doped layers 137, the second conductivity type doped well regions 133, and the second conductivity type doped layers 135.

Subsequently, the drain electrode 175 may be formed by depositing a conductive material on the second surface of the first conductivity type substrate 110, e.g., the lower surface and patterning it. The drain electrode 175 may abut the first conductivity type substrate 110.

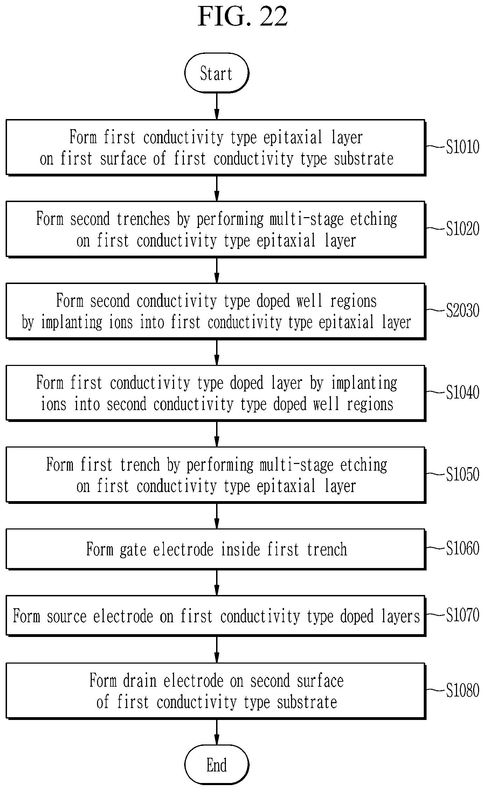

Now, a method of manufacturing a semiconductor device according to at least one example embodiment will be described with reference to FIGS. 22 to 24.

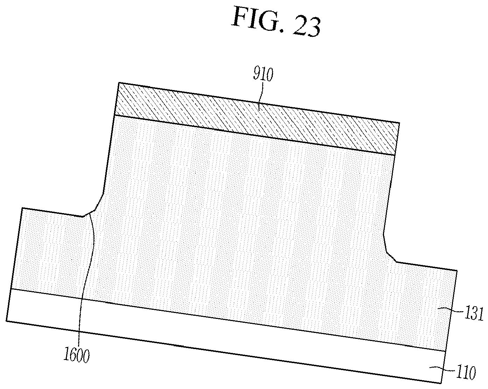

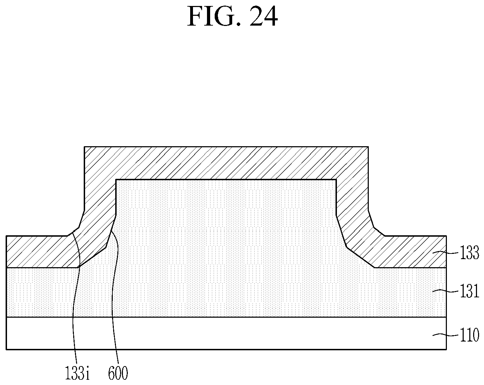

FIG. 22 is a flow chart illustrating a method of manufacturing a semiconductor device according to at least one example embodiment, and FIGS. 23 and 24 are cross-sectional views illustrating some processes of the method of manufacturing the semiconductor device according to the at least one example embodiment.

Similar to the above example embodiment, as shown in FIG. 23, a first conductivity type epitaxial layer 131 is formed on a first surface of a first conductivity type substrate 110 (S1010)

Subsequently, second preliminary trenches 1600 may be formed by performing multi-stage etching on the first conductivity type epitaxial layer 131 (S1020').

The first conductivity type epitaxial layer 131 may be formed relatively thicker as compared to the previous example embodiment. On the first conductivity type epitaxial layer 131, a first mask pattern 910 may be formed, and the second preliminary trenches 1600 may be formed by performing etching on the first conductivity type epitaxial layer 131 using the first mask pattern 910. As the second preliminary trenches 1600 are formed by performing multi-stage etching on the first conductivity type epitaxial layer 131, the side walls of each second preliminary trench 1600 may have a shape in which their inclination angles increase with the distance from the bottom surface.

As shown in FIG. 24, second conductivity type doped well regions 133 may be formed by implanting ions into the first conductivity type epitaxial layer 131 (S2030).

In the previous example embodiment, the second conductivity type doped well regions 133 are formed on the first conductivity type epitaxial layer 131 by the epitaxial growth method; however, in the present example embodiment, the second conductivity type doped well regions 133 may be formed in the first conductivity type epitaxial layer 131 by an ion implantation process. The second conductivity type doped well regions 133 may be formed from the upper surface of the first conductivity type epitaxial layer 131 to a predetermined depth. As some regions of the first conductivity type epitaxial layer 131 become the second conductivity type doped well regions 133, the thickness of the first conductivity type epitaxial layer 131 decreases. The inner surface 133i of each second conductivity type doped well region 133 may have substantially the same cross-sectional shape as that of a second preliminary trench 1600. In other words, each second conductivity type doped well region 133 may have a shape in which the side surfaces have inclination angles increasing with the distance from the inner bottom surface. Further, second trenches 600 of the first conductivity type epitaxial layer 131 may be the boundaries between the first conductivity type epitaxial layer 131 and the second conductivity type doped well regions 133. The second trenches 600 of the first conductivity type epitaxial layer 131 may have cross-sectional shapes similar to those of the second preliminary trenches 1600.

In the drawings, it is shown that in each second trench 600 of the first conductivity type epitaxial layer 131, the connection portion between the bottom surface and a side wall and the connection portions between the side walls having different slopes have angular shapes; however, the present disclosure is not limited thereto. For example, as in the at least one example embodiment of FIG. 5 or 6 described above, each connection portion may have a round shape or the like, and each second trench 600 may comprise a curved surface having a single curvature.

As the subsequent processes, processes identical to STEPS S1040 to S1080 of the previous example embodiment may be performed, whereby a semiconductor device having substantially the same (and/or similar) structure as that in the previous example embodiment may be formed.

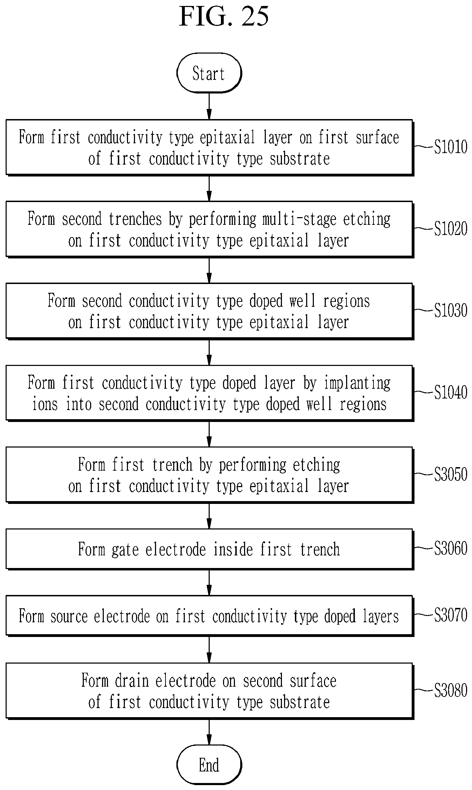

Now, a method of manufacturing a semiconductor device according to at least one example embodiment will be described with reference to FIGS. 25 to 29.

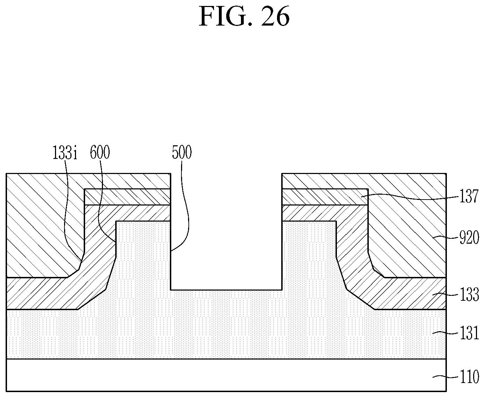

FIG. 25 is a flow chart illustrating a method of manufacturing a semiconductor device according to at least one example embodiment, and FIGS. 26 to 29 are cross-sectional views illustrating some processes of the method of manufacturing the semiconductor device according to the at least one example embodiment.

As in the above example embodiment, a first conductivity type epitaxial layer 131 may be formed on a first conductivity type substrate 110 (S1010), and second trenches 600 may be formed by performing multi-stage etching on the first conductivity type epitaxial layer 131 (S1020). On the first conductivity type epitaxial layer 131, second conductivity type doped well regions 133 and a first conductivity type doped layer 137 may be formed (S1030 and S1040).

As shown in FIG. 26, a first trench 500 may be formed by performing etching on the first conductivity type doped layer 137 (S3050).

A second mask pattern 920 may be formed on the first conductivity type epitaxial layer 131, the second conductivity type doped well regions 133, and the first conductivity type doped layer 137, and the first trench 500 may be formed by sequentially performing etching on the first conductivity type doped layer 137, the second conductivity type doped well regions 133, and the first conductivity type epitaxial layer 131 using the second mask pattern 920. The portion of the first conductivity type doped layer 137 and the portions of the second conductivity type doped well regions 133 that are not covered by the second mask pattern 920 may be removed, whereby the thickness of the portion of the first conductivity type epitaxial layer 131 may be reduced. The portion from which the first conductivity type epitaxial layer 131 has been removed may become the first trench 500.

The first trench 500 may be formed by a multi-stage etching process having process conditions different from those in the above example embodiment, and in the present example embodiment, the first trench 500 may be formed by performing an etching process having a single process condition. Accordingly, the inclination angles of the side walls of the first trench 500 may be constant. In other words, the side walls of the first trench 500 may have a single inclination angle, rather than various inclination angles. For example, the angles of the side walls of the first trench 500 with respect to the bottom surface may be about 90°. However, this is merely an example, and the angles of the side walls of the first trench 500 with respect to the bottom surface may be variously changed.

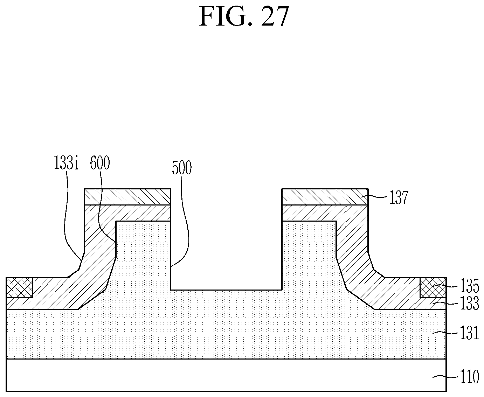

As shown in FIG. 27, the second mask pattern 920 may be removed, and the second conductivity type doped layers 135 may be further formed in the second conductivity type doped well regions 133.

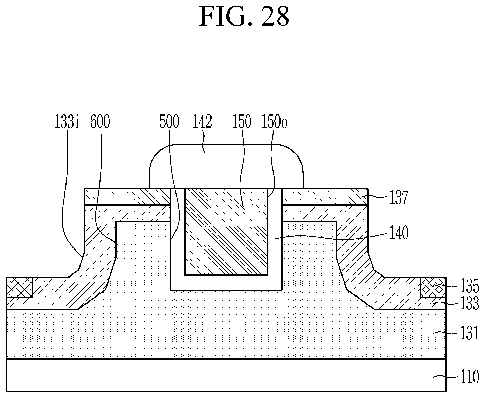

As shown in FIG. 28, a gate electrode 150 may be formed inside the first trench 500 (S3060).

First, when a high-temperature oxidation process is performed on the inside of the first trench 500, at least a portion of the first conductivity type epitaxial layer 131 constituting the bottom surface and side walls of the first trench 500 may be oxidized, whereby a gate insulating layer 140 may be formed.

Subsequently, a gate material layer may be formed by depositing polysilicon on the gate insulating layer 140, the first conductivity type doped layers 137, the second conductivity type doped well regions 133, and the second conductivity type doped layers 135. The gate material layer may be patterned such that the gate material layer remains inside the first trench 500. In other words, only the portion of the gate material layer positioned on the gate insulating layer 140 may remain.

The gate electrode 150 may have a cross-sectional shape similar to that of the first trench 500. The gate electrode 150 may be formed so as to have an appropriately rectangular shape as seen in a cross-sectional view. The inclination angles of the side surfaces of the gate electrode 150 may be constant. In other words, the side surfaces of the gate electrode 150 may have a single inclination angle, rather than various inclination angles. For example, the angles of the side surfaces of the gate electrode 150 with respect to the lower surface may be about 90°. However, this is merely an example, and the angles of the side surfaces of the gate electrode 150 with respect to the lower surface may be variously changed.

Subsequently, a capping layer 142 may be formed by depositing an insulating material on the gate electrode 150, the gate insulating layer 140, the first conductivity type doped layers 137, the second conductivity type doped well regions 133, and the second conductivity type doped layers 135 and patterning it.

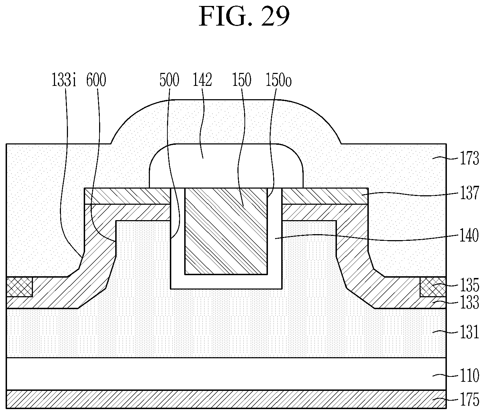

As shown in FIG. 29, a source electrode 173 may be formed on the first conductivity type doped layers 137 (S3070), and a drain electrode 175 may be formed on the second surface of the first conductivity type substrate 110 (S3080).

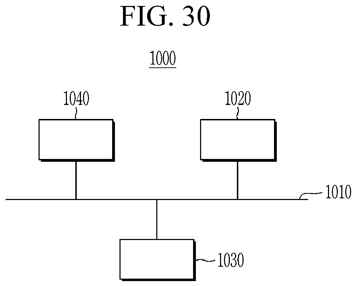

FIG. 30 is a schematic of an electronic device according to at least one embodiment.

Referring to FIG. 30, the electronic device 1000 includes one or more electronic device components, including a processor (e.g., processing circuitry) 1020 and a memory 1030 that are communicatively coupled together via a bus 1010.

The processing circuitry 1020, may be included in, may include, and/or may be implemented by one or more instances of processing circuitry such as hardware including logic circuits, a hardware/software combination such as a processor executing software; or a combination thereof. For example, the processing circuitry 1020 may include, but is not limited to, a central processing unit (CPU), an application processor (AP), an arithmetic logic unit (ALU), a graphic processing unit (GPU), a digital signal processor, a microcomputer, a field programmable gate array (FPGA), a System-on-Chip (SoC) a programmable logic unit, a microprocessor, or an application-specific integrated circuit (ASIC), etc. In some example embodiments, the memory 1030 may include a non-transitory computer readable storage device, for example a solid state drive (SSD), storing a program of instructions, and the processing circuitry 1020 may be configured to execute the program of instructions to implement the functionality of the electronic device 1000.

In some example embodiments, the electronic device 1000 may include one or more additional components 1040, coupled to bus 1010, which may include, for example, a power supply, a light sensor, a light-emitting device, any combination thereof, and/or the like. In some example embodiments, one or more of the processing circuitry 1020, memory 1030, or one or more additional components 1040 may include any of the semiconductor devices according to any of the example embodiments described with reference to, e.g., FIGS. 1, 7-9, and/or the like.

While this disclosure has been described in connection with what is presently considered to be practical some example embodiments, it is to be understood that the invention is not limited to the disclosed embodiments. On the contrary, it is intended to cover various modifications and equivalent arrangements included within the scope of the appended claims.

## Claims

1. A semiconductor device comprising:
a substrate having a first conductivity type;
a first conductivity type epitaxial layer on a first surface of the substrate, the first conductivity type epitaxial layer defining a first trench;
a gate electrode inside the first trench;
a gate insulating layer insulating the first conductivity type epitaxial layer from the gate electrode;
a source electrode on the first conductivity type epitaxial layer;
second conductivity type doped well regions and first conductivity type doped layers between the first conductivity type epitaxial layer and the source electrode; and
a drain electrode on a second surface of the substrate,
wherein the gate electrode includes:
a lower surface facing a bottom surface of the first trench,
an upper surface opposite to the lower surface, and
n number of side surfaces connecting the lower surface and the upper surface,
wherein an angle of the m-th side surface of the gate electrode with respect to the lower surface of the gate electrode is different from an angle of the (m-1)-th side surface of the gate electrode with respect to the lower surface of the gate electrode,
wherein n is a natural number greater than 2, and
wherein m is equal to or smaller than n.

2. The semiconductor device of claim 1, wherein
the m-th side surface of the gate electrode is closer to the lower surface of the gate electrode than the (m-1)-th side surface of the gate electrode is to the lower surface of the gate electrode, and
the angle of the (m-1)-th side surface of the gate electrode with respect to the lower surface of the gate electrode is larger than the angle of the m-th side surface of the gate electrode with respect to the lower surface of the gate electrode.

3. The semiconductor device of claim 1 or claim 2, wherein the n number of side surfaces of the gate electrode include:
a first side surface extending down from the upper surface of the gate electrode; and
a second side surface extending down from the first side surface, and
wherein an angle of the first side surface of the gate electrode with respect to the lower surface of the gate electrode is larger than an angle of the second side surface of the gate electrode with respect to the lower surface of the gate electrode.

4. The semiconductor device of claim 3, wherein:
the n number of side surfaces of the gate electrode further include a third side surface extending down from the second side surface of the gate electrode, and
the angle of the second side surface of the gate electrode with respect to the lower surface of the gate electrode is larger than an angle of the third side surface of the gate electrode with respect to the lower surface of the gate electrode.

5. The semiconductor device of claim 4, wherein:
n is 3,
the angle of the first side surface of the gate electrode with respect to the lower surface of the gate electrode is in a range from 75° to 90°,
the angle of the second side surface of the gate electrode with respect to the lower surface of the gate electrode is in a range from 40° to 75°, and
the angle of the third side surface of the gate electrode with respect to the lower surface of the gate electrode is in a range from 0° to 40°.

6. The semiconductor device of any preceding claim, wherein angles of the n number of side surfaces of the gate electrode with respect to the lower surface of the gate electrode gradually increase from the n-th side surface extending from the lower surface of the gate electrode to a first side surface extending down from the upper surface of the gate electrode.

7. The semiconductor device of any preceding claim, wherein the first trench includes:
the bottom surface; and
n number of side walls extending from the bottom surface, and
an angle of the m-th side wall of the first trench with respect to the bottom surface of the first trench is different from an angle of the (m-1)-th side wall of the first trench with respect to the bottom surface of the first trench.

8. The semiconductor device of claim 7, wherein the n number of side walls of the first trench include:
a first side wall at the top of the first trench;
a second side wall extending from the first side wall; and
a third side wall extending from the second side wall,
wherein an angle of the first side wall of the first trench with respect to the bottom surface of the first trench is larger than an angle of the second side wall of the first trench with respect to the bottom surface of the first trench, and
the angle of the second side wall of the first trench with respect to the bottom surface of the first trench is larger than an angle of the third side wall of the first trench with respect to the bottom surface of the first trench.

9. The semiconductor device of claim 7 or claim 8, wherein angles of the n number of side walls of the first trench with respect to the bottom surface of the first trench gradually increase from the n-th side wall of the first trench, extending from the bottom surface of the first trench, to the first side wall of the first trench positioned at the top of the first trench.

10. The semiconductor device of any preceding claim, wherein
the first conductivity type epitaxial layer further includes a second trench spaced apart from the first trench, and
the second conductivity type doped well regions are inside the second trench.

11. The semiconductor device of claim 10, wherein the second conductivity type doped well region includes:
an inner bottom surface facing a bottom surface of the second trench; and
k number of side surfaces extending from the inner bottom surface, and
an angle of the j-th side surface of the second conductivity type doped well region with respect to the inner bottom surface of the second conductivity type doped well region is different from an angle the (j-1)-th side surface of the second conductivity type doped well region with respect to the inner bottom surface of the second conductivity type doped well region, and
k is a natural number greater than 2, and
j is equal to or smaller than k.

12. The semiconductor device of claim 11, wherein the k number of side surfaces of the second conductivity type doped well region include:
a first side surface adjacent to the first conductivity type doped layer;
a second side surface extending from the first side surface; and
a third side surface extending from the second side surface, and
wherein an angle of the first side surface of the second conductivity type doped well region with respect to the inner bottom surface of the second conductivity type doped well region is larger than an angle of the second side surface of the second conductivity type doped well region with respect to the inner bottom surface of the second conductivity type doped well region, and
the angle of the second side surface of the second conductivity type doped well region with respect to the inner bottom surface of the second conductivity type doped well region is larger than an angle of the third side surface of the second conductivity type doped well region with respect to the inner bottom surface of the second conductivity type doped well region.

13. The semiconductor device of claim 11 or claim 12, wherein angles of the k number of side surfaces of the second conductivity type doped well region with respect to the inner bottom surface of the second conductivity type doped well region gradually increase from the k-th side surface extending from the inner bottom surface of the second conductivity type doped well region to the first side surface adjacent to the first conductivity type doped layers.

14. The semiconductor device of any of claims 11 to 13, wherein the second trench includes:
a bottom surface; and
k number of side walls extending from the bottom surface of the second trench, and
an angle of the j-th side wall of the second trench with respect to the bottom surface of the second trench is different from an angle of the (j-1)-th side wall of the second trench with respect to the bottom surface of the second trench.

15. The semiconductor device of claim 14, wherein the k number of side walls of the second trench include:
a first side wall at the top of the second trench;
a second side wall extending from the first side wall; and
a third side wall extending from the second side wall, and
wherein an angle of the first side wall of the second trench with respect to the bottom surface of the second trench is larger than an angle of the second side wall of the second trench with respect to the bottom surface of the second trench, and
the angle of the second side wall of the second trench with respect to the bottom surface of the second trench is larger than an angle of the third side wall of the second trench with respect to the bottom surface of the second trench.
